(19) Europäisches Patentamt
European Patent Office
Office européen des brevets

(11) Publication number: **0 124 256**
**B1**

(12) # EUROPEAN PATENT SPECIFICATION

(45) Date of publication of patent specification: **01.06.88**

(21) Application number: **84302098.3**

(22) Date of filing: **28.03.84**

(51) Int. Cl.⁴: **H 01 L 23/28,** H 01 L 29/201, H 01 L 29/80

(54) **MESFETs and methods of manufacturing MESFETs.**

(30) Priority: **28.03.83 JP 53407/83**

(43) Date of publication of application:
**07.11.84 Bulletin 84/45**

(45) Publication of the grant of the patent:
**01.06.88 Bulletin 88/22**

(84) Designated Contracting States:
**DE FR GB**

(56) References cited:
**EP-A-0 027 395**
**EP-A-0 046 422**
**EP-A-0 054 998**
**JOURNAL OF APPLIED PHYSICS, vol. 50, no. 5, May 1979, New York, USA H.C. CASEY et al. "Investigation of heterojunctions for MIS devices with oxygen-doped AlxGa1-xAs on n-type GaAs", pages 3484-3491**
**ELECTRONICS LETTERS, vol. 17, no. 22, 29 October 1981, London, GB Y. ISHII et al. "Self-aligned normally-off GaAs MESFET using Sn-doped SiO2 glass", pages 834-836**

(73) Proprietor: **FUJITSU LIMITED**
**1015, Kamikodanaka Nakahara-ku**
**Kawasaki-shi Kanagawa 211 (JP)**

(72) Inventor: **Takeuchi, Yukihiro**
**Haitsu Kawabata 101 980-7 Tokaichiba-cho**
**Midori-ku**
**Yokohama-shi Kanagawa 227 (JP)**
Inventor: **Hirachi, Yasutake**
**3-14-15 Nishikubo Musashino-shi**
**Tokyo 180 (JP)**
Inventor: **Takikawa, Masahiko**
**1156-8 Onda-cho Midori-ku**
**Yokohama-shi Kanagawa 227 (JP)**
Inventor: **Kasai, Kazumi**
**Kopo Sekino 201 1-11-3 Mizuhiki**
**Atsugi-shi Kanagawa 243 (JP)**
Inventor: **Ozeki, Masashi**
**30-1 Enokigaoka Midori-ku**
**Yokohama-shi Kanagawa 227 (JP)**

(74) Representative: **Fane, Christopher Robin King et al**
**HASELTINE LAKE & CO. Hazlitt House**
**28 Southampton Buildings Chancery Lane**
**London, WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 124 256 B1

(56) References cited:
**ELECTRONICS LETTERS, vol. 17, no. 6, 19 March 1981, London, GB T. ISHIBASHI "InP MESFET with In0.53Ga0.47As/InP heterostructure contacts", pages 215-216**

**Description**

The present invention relates to MESFETS and methods of manufacturing MESFETS.

A compound semiconductor such as gallium arsenide (GaAs) or indium gallium arsenide phosphide (InGaAsP) is used in fabricating a semiconductor device such as a MESFET for a micro-wave frequency or a light emitting device to obtain the best use of the characteristics of the compound semiconductor.

Such semiconductor devices must include a passivation layer. For example, a layer of silicon dioxide ($SiO_2$) or silicon nitride ($Si_3N_4$) is used for passivating the surface of a layer of a compound semiconductor. Such an $SiO_2$ or $Si_3N_4$ layer is excellent as a passivation layer for a semiconductor device using silicon, but is not always preferred for a semiconductor device using a compound semiconductor. This is because such an $SiO_2$ or $Si_3N_4$ passivation layer has a different lattice constant to that of a layer of a compound semiconductor such as GaAs, making the interface between the two layers chemically unstable and increasing the surface state density. The electrical characteristics of a semiconductor device using the compound semiconductor are, therefore, not stable, and are sensitive to contamination in the surrounding atmosphere.

Investigations into a preferable passivation layer to replace the $SiO_2$ or $Si_3N_4$ layer for use in a compound semiconductor device have been made heretofore. For example, for GaAs, plasma oxidation or anode oxidation of the surface of a GaAs layer has been tried, so as to obtain an oxidized GaAs surface layer; from the viewpoint that a layer of an oxidized material of a compound semiconductor is desired as a passivation layer for the compound semiconductor layer, as an $SiO_2$ layer is preferred for an Si layer. However, desirable results have not been obtained as yet, since all of these techniques have process difficulties and the resultant oxidized layers are chemically unstable.

At present, an $SiO_2$ or $Si_3N_4$ layer made by chemical vapor deposition (CVD) or plasma CVD must be used for a passivation layer in a compound semiconductor device. However, production of such a passivation layer necessitates very careful handling and a strictly controlled environment during production in order to reduce the contamination of the surface of the GaAs and, therefore, control of such procedures for fabrication are complex.

MISFETs using an aluminum gallium arsenide (AlGaAs) layer as an insulating layer between a GaAs active layer and a metal gate were proposed, (see J. P. Andre et al "(Ga, Al)As-GaAs MIS Heterostructure with Semi-Insulating (Ga, Al)As Grown by MOVPE", GaAs and Related Compound, 1982; H. C. Casey et al "Investigation of Heterojunction for MIS Devices with Oxygen-Doped $Al_xGa_{1-x}As$ on n-Type GaAs", J. Appl. Phys. 50(5), May 1979, pp 3484—3491). However, they do not relate to a MESFET and, therefore, do not include evaluation of an AlGaAs layer as a passivation layer for an GaAs active layer in a MESFET.

It has also been proposed in EP—A—0 027 395 to employ a layer of $Ga_xAl_{1-x}As$, wherein x is from 0 to 1, as a passivation layer on the surface of an active GaAs layer in an FET. The GaAs and GaAlAs layers are grown successively by epitaxial deposition, and windows are then etched in the GaAlAs layer through which metal is deposited to form source, drain and gate electrodes in contact with the active GaAs layer. GaInP and other ternary compounds of Group 3 and 5 elements, having crystal lattice constants similar to that of GaAs, may also be used as the passivation layer.

It is desirable to provide a MESFET having a passivation layer on a compound semiconductor active layer which does not adversely affect the operation of the active layer in the interfacial region of the two layers, and which has an improved radio frequency (RF) performance.

The present invention provides a MESFET comprising

— an active layer of a first compound semiconductor having an outwardly-widening recess at the top surface thereof, the recess having inclined side walls on opposite sides thereof;
— source and drain electrodes on and in contact with the top surface of said active layer outside and on said opposite sides of said recess and in alignment with said opposite side walls of said recess;
— a gate electrode on and in contact with said active layer in said recess and at a portion of the bottom of said recess between and spaced from each of said inclined side walls; and
— an insulating or semi-insulating layer of a second compound semiconductor covering the top surface of said active layer and the surfaces of the inclined side walls and the bottom of the recess in the portions between said source, drain, and gate electrodes, said second compound semiconductor being composed of components including at least one of the components of said first compound semiconductor and having a forbidden band gap wider than that of said first compound semiconductor.

The second compound semiconductor may have a lattice constant substantially that of the first compound semiconductor.

The inventors of the present invention found that a layer of the second compound semiconductor as stated above may make an excellent interface with a layer of the first compound semiconductor, in which the layer of the first compound semiconductor is not adversely affected in the interfacial region by the second compound semicompound.

The second compound semiconductor should be insulating or semi-insulating and have a forbidden band gap wider than that of the first compound semiconductor, in order to function as a passivation layer for the first compound semiconductor.

The preferred combinations of the first compound semiconductor to be used for an active layer and the second compound semiconductor to be used for a passivation layer include, for example, a passivation layer of $Al_xGa_{1-x}As$ wherein x is between 0.2 and 0.5, preferably 0.3, for an active layer of GaAs; a passivation layer of InP for an active layer of $In_yGa_{1-y}As$ wherein y is 0.53; a passivation layer of $Al_zIn_{1-z}As$ wherein z is 0.48 for an active layer of InP; and a passivation layer of $Al_yIn_{1-y}As$ wherein y is 0.48 for an active layer of $In_yGa_{1-y}As$ wherein y is 0.53. The forbidden band gap of $Al_xGa_{1-x}As$ is between 1.7 and 1.95 when x is between 0.2 to 0.5. The lattice constant and forbidden band gaps of the compound semiconductor mentioned above are shown in the following Table.

TABLE

| | Active layer | Passivation layer |
|---|---|---|
| | GaAs | $Al_{0.3}Ga_{0.7}As$ |
| Lattice constant | 0.565 nm | 0.565 nm |
| Forbidden band gap* | 1.4 eV | 1.8 eV |
| Resistivity | — | $10^8$ Ωcm |
| | $In_{0.53}Ga_{0.47}As$ | InP |
| Lattice constant | 0.586 nm | 0.586 nm |
| Forbidden band gap* | 0.8 eV | 1.35 eV |
| Resistivity | — | $10^5$ Ωcm |
| | InP | $Al_{0.48}In_{0.52}As$ |
| Lattice constant | 0.586 nm | 0.586 nm |
| Forbidden band gap* | 1.35 eV | 1.8 eV |
| Resistivity | — | $10^8$ Ωcm |
| | $In_{0.53}Ga_{0.47}As$ | $Al_{0.48}In_{0.52}As$ |
| Lattice constant | 0.586 nm | 0.586 nm |
| Forbidden band gap* | 0.8 eV | 1.8 eV |
| Resistivity | — | $10^8$ Ωm |

*The lattice constant can be controlled in the order of $10^{-5}$ nm.

Embodiments of a process for fabricating a MESFET according to the present for fabricating a MESFET invention will be described later. A process for fabricating a MESFET according to the present invention may has an advantage, for example, in that a passivation layer of AlGaAs having a higher resistivity of $10^8$ Ωcm may extend under extending lines from the source, drain, and gate electrodes and bonding pads connected thereto, allowing the improvement of the isolation of each electrode including the bonding pad connected thereto from other electrodes, including the bonding pads connected thereto (GaAs of a semi-insulating substrate has a resistivity of only $10^6$ Ωcm).

A passivation layer of a compound semiconductor may be formed by any one of the conventional methods, for example, molecular beam epitaxy (MBE) or metal organic CVD (MOCVD).

Reference will now be made, by way of example, to the accompanying drawings, in which:

Figure 1a is a sectional view of an MOS diode, and Figure 1b is a graph showing the MOS capacitance characteristic as a function of gate voltage for theoretical and experimental MOS diodes;

Figure 2 shows the result of Auger analysis of the interfacial region between the $SiO_2$ and GaAs layers in Figure 1a;

Figures 3a, 3b, and 3c are sectional views showing the geometrical structure of prior art MESFETs having various recess lengths;

Figure 4 shows RF characteristics of MESFETs shown in Figures 3a, 3b, and 3c;

Figure 5 is a block diagram of a circuit for measuring frequency dispersion;

Figures 6a and 6b are graphs of normalized transconductance vs frequency;

Figure 7 illustrates frequency dispersion of the transconductance at a various gate bias (G—V characteristic);

Figure 8 illustrates frequency dispersion of the transconductance of MESFETs using an $SiO_2$ and $Si_3N_4$ passivation layer;

Figure 9 is a graph of frequency dispersion of the transconductance of MESFETs having various recess lengths;

Figures 10a and 10b are graphs of the drain current vs drain voltage (I—V) characteristic;

Figure 11 is a sectional view of an apparatus for MOCVD;

Figure 12 is a graph of the ratio of mixed crystal vs mole ratio of feed gases;

Figure 13 is a graph of growth rate vs temperature of substrate;

Figure 14 is a graph of layer thickness ratio vs position in a wafer;

Figure 15 is a sectional view of a MIS diode having an insulating $Al_xGa_{1-x}As$ layer;

Figure 16 is a block diagram of an apparatus for measuring the capacitance vs voltage (C—V) characteristic;

Figure 17 is a graph of the C—V characteristic of an MIS diode embodying to the present invention;

Figure 18 is a graph of the G—V characteristic of an active layer of the MIS diode;

Figure 19 is a graph of the carrier concentration in an active layer of the MIS diode;

Figure 20 is a graph of the interface potential vs applied voltage;

Figure 21 is a graph of the I—V characteristic;

Figure 22 shows MIS capacitances in MIS diodes having various x values;

Figure 23 shows a profile of Al mole fraction around the interface of AlGaAs and GaAs layers.

Figures 24 to 27 are sectional views of a GaAs MESFET during the steps of a process for fabrication thereof;

Figure 28 shows transconductance of a GaAs MESFET embodying the present invention;

Figure 29 shows the RF characteristics of a GaAs MESFET embodying the present invention;

Figure 30 is a sectional view of a GaAs MESFET of another embodiment of the present invention; and

Figure 31 is a sectional view of a GaAs MESFET, not according to the present invention, illustrating the use of ion implantation to form source and drain regions.

First, descriptions of the prior art, referring to the drawings, are made to facilitate understanding of the present invention.

Figure 1a shows an MOS diode in which 1 denotes a semi-insulating GaAs substrate including a GaAs buffer layer not shown in the Figure, 2 an n-type epitaxial GaAs layer, 3 an $SiO_2$ layer, 4 a circular gold (Au) electrode, and 5 an ohmic contact electrode. The n-type epitaxial GaAs layer 2 contains an n-type impurity concentration of $9.29 \times 10^{16}$ $cm^{-3}$, as used in a standard GaAs FET. The $SiO_2$ layer 3 is 500 nm thick and produced by chemical vapor deposition (CVD).

Figure 1b shows curves of MOS capacitance in relation to gate voltage, in which the solid line and the broken line correspond to the theoretical and experimental curves respectively. In the figure, when the applied voltage decreases from +20 volts to −20 volts, the MOS capacitance of theoretical curve decreases from 0.2 pF to 0.185 pF (approximately 7.5% decrease), while the MOS capacitance of the experimental curve is not changed at all. This means that a large amount of surface states are present at the interface of the $SiO_2$ layer 3 and the n-type GaAs layer 2 and the voltage externally applied to the MOS diode applies only to the $SiO_2$ layer 3, not to the region inside the n-type GaAs layer 2.

Auger analysis was effected on the MOS diode. Figure 2 illustrates the ratio of the number of the atoms of the component elements of the $SiO_2$ layer 3 and the GaAs layer 2 in the direction perpendicular to the interface of the two layers 2 and 3, in which S, O, G, and A denote silicon, oxide, gallium, and arsenic respectively. The figure clearly shows the interdiffusion of the component elements of the $SiO_2$ and GaAs layers, in particular, deep diffusion into the GaAs layer 2. Thus, a large amount of surface states are actually formed at the interfacial region of the $SiO_2$ and GaAs layers.

Such interface states formed at the interface of $SiO_2$ and GaAs layers will deteriorate the characteristics of a MESFET when an $SiO_2$ layer is used as a passivation layer for a GaAs active layer in the MESFET. Next will be discussed the RF characteristics of GaAs MESFETs in relation to surface states.

The structure of such prior art MESFETs is illustrated by Figures 3a, 3b, and 3c, in which 11 denotes a semi-insulating GaAs substrate which includes a GaAs buffer layer not shown in the Figures, 12 a GaAs active layer, 13 a recess, 14 a source electrode, 15 a drain electrode, 16 a gate electrode, and 17 a passivation layer. The MESFETs in Figures 3a, 3b, and 3c are similar to each other and are formed on the same wafer, but have different recess lengths $L_1$, $L_2$, and $L_3$ of 1 μm, 2 μm, and 3 μm, respectively. These three MESFETs in Figures 3a, 3b, and 3c are hereinafter referred to as A-Type, B-Type, and C-Type MESFETs, respectively.

It is known that the length $L_n$ of the recess has a remarkable influence on the RF characteristics of such MESFETs. For example, the input-output characteristics, etc. (shown in Figure 4) of the above-mentioned three types of MESFETs with a gate width Wg of 0.6 mm were obtained by operating them at 16.5 GHz, a source-drain voltage $V_{SD}$ of 10 V, and a source-drain current $I_{SD}$ of 75 mA. In the Figure, ○, ●, and □

represent the RF characteristics of the A-Type, B-Type, and C-Type MESFETs, respectively.

Referring to the Figure, in the A-Type MESFET, while the linear gain is approximately 6 dB, the input-output characteristic is excellent, since the characteristic line is substantially linear without saturation of the output up to approximately 20 dBm of input, and the power added efficiency $\eta_{add}$ then reaches up to 30%. The gate leakage current at RF operation Ig (RF) however becomes extremely large in the minus direction, which eliminates practical use. In the B-Type, the linear gain is approximately 8 dB, the saturation of output begins from approximately 14 dBm of input, and the power added efficiency $\eta_{add}$ is 15% or more. The gate leakage current Ig (RF) becomes approximately some hundreds of micro Amperes in the minus direction and then turns toward the plus direction as the input power increases. In the C-Type, while the linear gain is as high as 10 dB, the saturation of output power begins from 10 dBm of input and the power added efficiency $\eta_{add}$ often does not reach as much as 15%. The gate leakage current Ig (RF) is small, and a few micro Amperes in the minus direction, and turns toward the plus direction when the input increases up to approximately 20 dBm.

While a MESFET is ideal if no gate leakage current Ig (RF) is carried, the saturation of output power does not occur until input power is increased, and the power added efficiency is higher than 30%, in practice, a C-Type MESFET having a small gate leakage current Ig (RF) selected for reliability, or an intermediate one between C-Type and B-Type MESFETs is chosen for optimization.

The reasons for this influence of the recess length $L_n$ on the high frequency characteristics of MESFET is not known, since the RF characteristics of such three types of MESFETs are remarkably different, as shown in Figure 4, but the DC characteristics of such MESFETs are not significantly different from each other (the DC characteristics are drain-source current vs drain-source voltage ($I_{DS}$–$V_{DS}$) characteristics. However, a group including M. Ozeki, one of the inventors of the present invention, clarified this problem by measuring the frequency characteristic of the transconductance $g_m$ of a GaAs MESFET (M. Ozeki, K. Kodama, and A. Shibatomi, "Surface Analysis in GaAs MESFET by Frequency-Dispersion Measurement of Transconductance", 9th International Symposium on GaAs and Related Compound, Inst. of Phys. Conf., Ser 63, pp 323—328).

Figure 5 is a block diagram of a circuit used in the above surface analysis for determining the frequency dispersion of transconductance $g_m$. In the Figure, OSC represents an oscillator, DCS a direct current source, BC a bias circuit, MC a matching circuit, SAM a sample, WBA a wide band amplifier, PSA a phase-sensitive amplifier, and DCA a direct current amplifier. In this circuit, measurement is carried out by applying a gate bias and a drain bias to a sample, and then applying low power level input signals at various frequencies to the gate of the sample.

Figure 6a is a graph of the frequency characteristic of the transconductance $g_m$ of a GaAs MESFET, and Figure 6b is that of the GaAs MESFET in which the $SiO_2$ passivation layer is removed, e.g., by chemical etching. The characteristics shown in Figures 6a and 6b are measured by the measurement circuit shown in Figure 5 and normalized to the transconductance $g_m$ at 0.2 Hz. In the measurements, the drain-source voltage $V_{DS}$ is applied at 0.05 V and the gate-source voltage $V_{GS}$ at −0.5 V.

Frequency dispersion of the transconductance $g_m$ occurs between 100 Hz and 200 Hz (see Figure 6a) while the frequency dispersion of the transconductance $g_m$ disappears (see Figure 6b). Therefore, it is recognized that the frequency dispersion of the transconductance $g_m$ is caused by the condition of the surface of the active layer of the MESFET.

Figure 7 illustrates the frequency dispersion of the transconductance $g_m$ when varying the gate bias voltage $V_g$ of the same sample shown in Figure 6a, the varied gate bias voltages $V_g$ being 0 V, −0.5 V, −1.0 V, and −2.0 V. In the figure, the frequency dispersion of the transconductance $g_m$ decreases with the depth of the gate bias voltage $V_g$ (i.e., increasing the gate bias voltage $V_g$ in the minus direction), and has almost disappeared at a $V_g$ of −2.0 V. This suggests that the above-mentioned frequency dispersion of the transconductance $g_m$ is remarkably influenced by a surface depletion layer based on the surface state when a depletion layer formed under the gate by gate bias is as shallow as the surface depletion layer based on the surface state, but it is not influenced by the surface depletion layer when a depletion layer by the gate bias is substantially deeper than the depletion layer based on the surface state.

Figure 8 illustrates the frequency dispersion of the transconductance $g_m$ of GaAs MESFETs which are fabricated in each of two halves cut from a single wafer, and by the same process, except for using an $SiO_2$ layer and an $Si_3N_4$ layer as a passivation layer, respectively. In the measurement, the drain-source voltage $V_{DS}$ and the gate-source voltage $V_{GS}$ are 0.05 V and −0.5 V, respectively. In the figure, the MESFET using an $SiO_2$ passivation layer has a frequency dispersion between 100 Hz and 200 Hz (Curve A), while the MESFET using an $Si_3N_4$ passivation layer has a frequency dispersion at 10 Hz (Curve B). This suggests that the characteristics of a MESFET, more particularly those at the interface with a passivation layer, are largely influenced by the kind of passivation layer used. The frequency dispersion at $10^5$ Hz (see Figure 8b, Curve C) is considered to be caused by trapping at the interface of an active layer and a buffer layer.

Figure 9 illustrates the frequency dispersion of the transconductances $g_m$ of the before-mentioned A-Type, B-Type, and C-Type MESFETs having various recess lengths $L_n$, the measurement of which is conducted at 0.05 V of the drain-source voltage and −0.5 V of the gate-source voltage, the transconductance $g_m$ being normalized. It can be seen from the Figure that the degrees of decrease of the transconductance $g_m$ in the region of a higher frequency are increased as the recess length L becomes longer. It was experimentally confirmed that, while this measurement is conducted at −0.5 V of gate-source

voltage, the degrees of the lowering of the transconductances $g_m$ are decreased and the difference of those degrees disappear between the three types as the absolute value of the gate bias is increased in the minus direction, as can be seen in Figure 7.

These experimental results make it possible to explain the difference of the linearities of the input-output characteristics shown in Figure 4.

If the I—V characteristics of GaAs MESFETs can be determined at an input frequency of 16.5 GHz, they will be as shown in Figures 10a and 10b. Figure 10a shows the characteristic for a MESFET, such as a C-Type, having a long recess length $L_3$ and having poor linearity of the input-output characteristic. Figure 10b shows the characteristic for a MESFET, such as an A-Type, having a short recess length $L_1$ and having good linearity. These two types of MESFETs biased at a drain-source voltage of +10 V show good linearity of the input-output characteristic, if the input signal is small. However, the sourc-drain current $I_{DS}$ will be saturated in the region R (see Figure 10a) if the input signal $V_{DS}$ becomes large. This means that when an input power increases, the amount of change of the source-drain current $I_{SD}$ is not proportional to the input power. However, such an nonproportional output power does not appear in Figure 10b.

From the above, we can assume that surface states are formed at the surface of a GaAs MESFET, more particularly, at the surface of a GaAs active layer of the GaAs MESFET, by influence from a passivation layer. Due to the surface states, a surface depletion layer appears from the surface toward the inside of the active layer, giving an adverse influence on the change of amplitude of the gate voltage, and deteriorating the linearity of the input-output characteristic of the MESFET.

In an embodiment of the present invention, an $Al_xGa_{1-x}As$ layer is used as a passivation layer for a GaAs active layer, which can help to reduce this problem.

Figure 11 illustrates an apparatus for growing an $Al_xGa_{1-x}As$ layer in which 21 denotes a reaction chamber, 22 a RF coil (work coil), 23 a gas feed pipe, 24 an exhaust pipe, 25 a carbon susceptor, 26 a mirror, 27 an infrared radiation thermometer, and 28 a substrate to be treated; the susceptor 28 being able to rotate in the reaction chamber 21, and the substrate being composed of GaAs.

The growing of an $Al_xGa_{1-x}As$ layer by the apparatus shown in Figure 11 is described in the following. A GaAs substrate 28 is placed on the carbon susceptor 25 heated by the work coil 22, the temperature of the substrate 28 or the susceptor 25 being monitored by the infrared radiation thermometer 27. The gas feed pipe 23 feeds the source gases, $Al_xGa_{1-x}As$, of trimethyl aluminum (TMA, $Al(CH_3)_3$), trimethyl gallium (TMG, $Ga(CH_3)_3$), and arsine ($AsH_3$), and a carrier gas of hydrogen ($H_2$), the flow rates and flow directions of which are initially precisely controlled at a gas control portion comprising valves and flow meters, etc. The growth of the $Al_xGa_{1-x}As$ occurs by pyrolysis of the TMA, TMG, and $AsH_3$ at the surface of the GaAs substrate 28 heated by the carbon susceptor, with the reactions shown below:

$$Al(CH_3)_3+\frac{3}{2}H_2\rightarrow Al+3CH_4$$

$$Ga(CH_3)_3+\frac{3}{2}H_2\rightarrow Ga+3CH_4$$

$$AsH_3+H_2\rightarrow As+\frac{5}{2}H_2$$

Figure 12 is a graph of the x value of $Al_xGa_{1-x}As$ versus the mole ratio of TMA to TMA plus TMG. The mole ratio is varied by maintaining the flow rate of TMG constant at 30 cc/min, and by changing the flow rate of TMA. The growth temperature of $Al_xGa_{1-x}As$ is set at 700°C. The x value is determined by an X-ray double crystal method. As can be seen in Figure 12, the x value is increased with the increase of the concentration of Al, i.e., the flow rate of TMA.

Figure 13 illustrates the growth rate of an $Al_xGa_{1-x}As$ layer. The flow rates of TMG and TMA are selected to be the same and to produce a layer of $Al_xGa_{1-x}As$ wherein x is 0.3 at the growth temperature of 700°C, and are 8.1 cc/min, 5.4 cc/min, and 2.7 cc/min. Varying the growth temperature, the growth rates of an $Al_{0.3}Ga_{0.7}As$ layer are plotted while keeping the flow rates of TMG and TMA constant. Generally speaking, the growth rate tends to decrease with the increase of the growth temperature, the degree of the change being larger if the feed rate of the III-group elements of the Periodic Table is larger. The growth rate is approximately proportional to the feed rate of the III-group elements at a temperature below 750°C.

The growth rate of an $Al_xGa_{1-x}As$ layer also varies according to the total flow rate of the gases. The growth rate is 0.027 μm/min at a total flow rate of 400 cc/min and 0.067 μm at 1000 cc/min, between which they are in a linear proportion relationship. This has been confirmed by experiment.

Figure 14 illustrates the uniformity of an $Al_xGa_{1-x}As$ layer. In the graph shown in Figure 14, the axis of the abscissa represents the position in a wafer, and the axis of the ordinates represents the thickness of the layer, normalized by the maximum thickness. The total flow rate of the gases is a parameter selected at 1000 cc/min, 400 cc/min and 300 cc/min. As can be seen in the Figure, a rapid decrease of the thickness of

the layer appears at 1000 cc/min, more particularly, a 25% decrease appears in a 9 mm distance. However, the thickness of the layer is considerably uniform at a decreased flow rate, and the deviation of the thickness is less than ±5% over a 20 mm length at 300 cc/min of the total flow rate of the gases.

A description of evaluation made of an $Al_xGa_{1-x}As$ layer and the surface of a GaAs active layer is given below.

In a GaAs MESFET using an $Al_xGa_{1-x}As$ passivation layer, the most important characteristics are the surface states at the interface of the passivation layer and the GaAs active layer and the withstand voltage of the passivation layer as an insulating layer.

In an MIS diode in which the insulator is of high resistive $Al_xGa_{1-x}As$ and the semiconductor is of n-type GaAs, and the structure of which is similar to the MIS diode shown in Figure 1a, an n-type GaAs active layer 32 is formed on an $n^+$-type GaAs substrate 31 by CVD without dopant (Figure 15). The resultant n-type GaAs active layer 32 has a carrier concentration of $5\times10^{15}$ to $10^6$ $cm^{-3}$.

The wafer in which the n-type GaAs layer 32 has been formed is taken out of the CVD apparatus before an $Al_xGa_{1-x}As$ layer 33 is formed on the n-type GaAs layer 32. This removal of the wafer is effected because, in the fabrication of a GaAs MESFET, an n-type GaAs active layer 32 is treated so that current to be carried in the active layer 32 during operation of the FET is controlled, which necessitates that the wafer be taken out of the CVD apparatus for the above-mentioned treatment. Such a removal of the wafer will deteriorate the surface of the n-type GaAs active layer 32. Therefore, the evaluations made include such a removal of the wafer.

The surface of the n-type GaAs active layer 32 is etched in the thickness of approximately 1.5 μm with an etchant comprising 90% $H_2SO_4$, 5% $H_2O_2$, and 5% $H_2O$ at 300 K for 30 seconds. The resultant wafer is then placed for 4 minutes in a gas flow of $AsH_3$ at 800°C, and an $Al_xGa_{1-x}As$ passivation layer 33 is grown for 50 minutes at 800°C while keeping the mole ratio of As/Ga+Al in a feed gas mixture at 40. The resultant $Al_xGa_{1-x}As$ layer 33 has an x value of 0.55 and a thickness of 1.4 μm.

A part of the $Al_xGa_{1-x}As$ passivation layer 33 and the n-type GaAs active layer 32 is selectively etched to expose the surface of the $n^+$-type GaAs substrate 31 on which a gold-germanium/gold (Au · Ge/Au) layer is formed by vapor-deposition and heat-treated for 2 minutes in a gas flow of nitrogen at 450°C, to form an electrode 34. A gold (Au) layer is deposited onto the $Al_xGa_{1-x}As$ layer 33 to form another electrode 35.

On the resultant samples of an MIS diode, the capacitance-voltage (C—V) characteristic is investigated in order to determine the amount of interface states, and the current-voltage (I—V) characteristic is checked in order to determine the withstand voltage of the $Al_xGa_{1-x}As$ passivation layer.

An apparatus shown in Figure 16 is used for the C—V characteristic measurement since it is necessary to change the frequency. In the Figure, 41 denotes a lock-in amplifier (PAR 126 produced by PAR), 41A a comparison output terminal, 42 a current amplifier (PAR 194 produced by PAR), 43 a function generator, 44 an X—Y recorder, 46 a ceramic condenser of, e.g., 0.1 μm, 46 an oxide-coated resistance of 200 kΩ, and 47 a sample. In operation, a sine wave voltage of 0.1 V P—P, from the comparison output terminal 31A of the lock-in amplifier 41, is applied to the sample 47, and the current carried through the sample 47 is amplified by the current amplifier 42 and measured. The components of the current, the phases of which are the same as and 90° shifted from the phase of the input voltage, correspond to conductance and capacitance respectively. Corrections of the absolute value and the phase of the capacitance C and the gain G are effected by the ceramic condenser 45 and the oxide-coated resistor 46. The measurement frequencies are 110 Hz, 1 kHz, 10 kHz, 100 kHz, and 1 MHz. The capacitance at 1 MHz is measured by a capacitance meter Boonton 72B.

Figures 17 and 18 are graphs of the C—V characteristic and G—V characteristic at a room temperature of 295 K, with measuring frequencies of 110 kHz, 1 kHz, 10 kHz, 100 kHz, and 1 MHz, the sweep speed of the voltage $\beta_r$ being 2 V/min. As can be seen from the Figures, upon reverse bias, no hysteresis appears in the C—V and G—V characteristics at various frequencies. The C—V characteristics and G—V characteristics each are the same at the frequency of above 1 kHz. In particular, the conductance G being zero within the deviation of measurement value.

It is recognized that the interface state density wherein the charged states can follow an input since wave voltage of above 110 Hz is $10^{10}$ $cm^{-2}eV^{-1}$ or less, based on the Terman method. Thus, the interface state density of the interface of the $Al_xGa_{1-x}As$ layer and the GaAs layer is $10^{10}$ $cm^{-2}eV^{-1}$ or less, based on the Terman method.

In the Figures, upon forward bias, right-handed rotation hysteresis appears in the C—V charactersitic and the G—V characteristic. Upon forward bias, electrons are injected into the $Al_xGa_{1-x}As$ passivation layer from the GaAs active layer. At an increased bias voltage, the injected electrons are caught in deep states (trape) in the $Al_xGa_{1-x}As$ passivation layer. The time constant of this catch is given by $nC_n$, wherein n is the injected electron density and $C_n$ is the probability of that catch. As the injected electron density is low, the time constant of the catch is later than the changing rate of the input voltage. When the bias voltage is increased, the space charge density in the $Al_xGa_{1-x}As$ layer becomes higher and, therefore, the capacitance is increased, resulting in a right-handed rotation hysteresis.

The capacitance is increased upon decrease of the frequency. It is considered that this phenomenon occurs since electric charges in the $Al_xGa_{1-x}As$ layer, which charges follow the change of the input sine wave voltage, are increased as the frequency is lowered.

In Figure 19, the carrier concentrations in the GaAs active layer before and after the formation of the

$Al_xGa_{1-x}As$ layer are compared. The carrier concentration after the formation of the $Al_xGa_{1-x}As$ layer is determined from the C—V characteristic at reverse bias. Complete depletion approximation is used for calculating the capacitance of the depletion layer in the GaAs active layer. This hypothesis can be applied at an interface potential of 0.5 V or above.

Figure 20 shows the interface potential in relation to the applied voltage. As seen in the Figure, at the applied voltage of 3.0 V or more, the interface potential becomes below the valence band, but inversion does not occur. This is because holes will flow away through the $Al_xGa_{1-x}As$ passivation layer since the step between the valence bands of the $Al_xGa_{1-x}As$ passivation layer wherein x is 0.55 and the GaAs active layer is as low as approximately 0.05 eV.

Figure 21 is a graph showing the I—V characteristic. As shown in the Figure, the current is increased in proportion to the square of the voltage at forward bias. This phenomenon occurs when a space-charge limited current is carried during injection of an almost single carrier, and suggests that electrons are injected into the $Al_xGa_{1-x}As$ passivation layer from the GaAs active layer. Further, the graph shows that the resistivity of the $Al_xGa_{1-x}As$ passivation layer is $10^8$ Ωcm or more.

From the I—V characteristic in the forward direction measured by a curve tracer, the breakdown voltage is found to be approximately 10 V. From this, it is confirmed that the withstand voltage of the $Al_xGa_{1-x}As$ passivation layer is approximately 7 kV/cm.

Figure 22 illustrates the capacitance of MIS diodes in relation to the applied voltage, the MIS diodes having an $Al_xGa_{1-x}As$ passivation layer other than that described above, wherein $T_G$ is the growth temperature. As can be seen in the Figure, while hysteresis upon reverse bias appears in the sample wherein x is 0.47 and $T_G$ is 700°C, all C—V characteristics are completely different from that of the sample in Figures 1a and 1b, and show that the interface states are $10^{10}$ $cm^{-2}eV$ or less in all cases.

Auger analysis is carried out on an MIS diode having an $Al_xGa_{1-x}As$ passivation layer on a GaAs active layer and made in the manner described before. Figure 23 is the resultant profile of Al mole fraction in the direction perpendicular to the interface of the $Al_xGa_{1-x}As$ passivation layer and the GaAs active layer. It is seen that the Al mole fraction sharply decreases near the interface of the two layers, and substantially no Al is present in the GaAs layer. This means that interdiffusion between the components of the two layers did not occur, resulting in the disappearance of the interface states.

Thus, according to the present invention, there is provided an $Al_xGa_{1-x}As$ layer in which the interface states are $10^{10}$ $cm^{-2}eV$ or less and the resistivity is $10^8$ Ωcm or more.

The fabrication of GaAs MESFETs according to an embodiment of the invention is described below with reference to the drawings.

Referring to Figure 24, a GaAs buffer layer 52 and an n-type GaAs active layer 53 are continuously epitaxially grown onto a semi-insulating GaAs substrate 51 of, e.g., approximately $10^6$ Ωcm resistivity and approximately 400 µm thickness, the n-type GaAs active layer 53 having a doped impurity concentration of $1.5 \times 10^{17}$ $cm^{-3}$ and a thickness of approximately 0.5 µm. So-called mesa-etching is conducted for isolation of the n-type GaAs active layer 53, and selective etching is conducted to form recesses 53A in the top surface of the n-type GaAs active layer 53. The depth of the recess 53A depends on the current to be carried between a source and a drain. For example, the depth and length L of the recess 53A are 200 to 300 nm and 1.5 to 2 µm respectively.

Referring to Figure 25, an $Al_xGa_{1-x}As$ passivation layer 54 of, e.g., approximately 500 nm, is formed over the n-type GaAs active layer 53 and the semi-insulating GaAs substrate 51 in the region exposed by the mesa-etching. The process for forming the $Al_xGa_{1-x}As$ layer 54 is the same as described earlier, wherein x is, for example, 0.3.

Referring to Figure 26, the $Al_xGa_{1-x}As$ passivation layer 54 is selectively etched by using a resist as a mask to open source contact windows and drain contact windows. An Au · Ge/Au layer is formed by vapor deposition. The resist is then removed together with the Au · Ge/Au layer superimposed on the resist, that is to say lift-off is effected for patterning. Heat treatment is conducted at 450°C for 2 minutes to make ohmic contact. Thus, source electrodes 55S and drain electrodes 55D are formed. The $Al_xGa_{1-x}As$ passivation layer 54 is again selectively etched by using a resist as a mask, to open gate contact windows, and an Al layer is deposited. The resist is then removed together with the Al layer superimposed on the resist, to form gate electrodes 56G.

Referring to Figure 27, an $SiO_2$ layer 57, e.g., 600 nm thick, is formed by CVD. The following process for fabricating GaAs MESFETs is conventional. For example, the $SiO_2$ layer 57 is patterned to form source-electrode-extending windows, drain-electrode-extending windows, and openings for bonding pads. An Au · Ge/Au layer 58 is formed and patterned to form source-electrode-extending lines 58S, drain-electrode-extending lines 58D, and bonding pads 58P. The bonding pads 58P are formed directly on the $Al_xGa_{1-x}As$ passivation layer 54 since the $SiO_2$ layer 57 is easily separated from the $Al_xGa_{1-x}As$ layer 54.

The transconductance $g_m$ of the thus obtained GaAs MESFET is measured by the method described before with reference to Figure 5. Figure 28 illustrates the results obtained from the measurement. It is seen in the Figure that the frequency dispersion of the transconductance $g_m$ hardly appears even if the gate bias voltage $V_G$ is changed from 0 V to −4 V. Therefore, the linearity of input power-output power characteristic will be clearly improved in this GaAs MESFET.

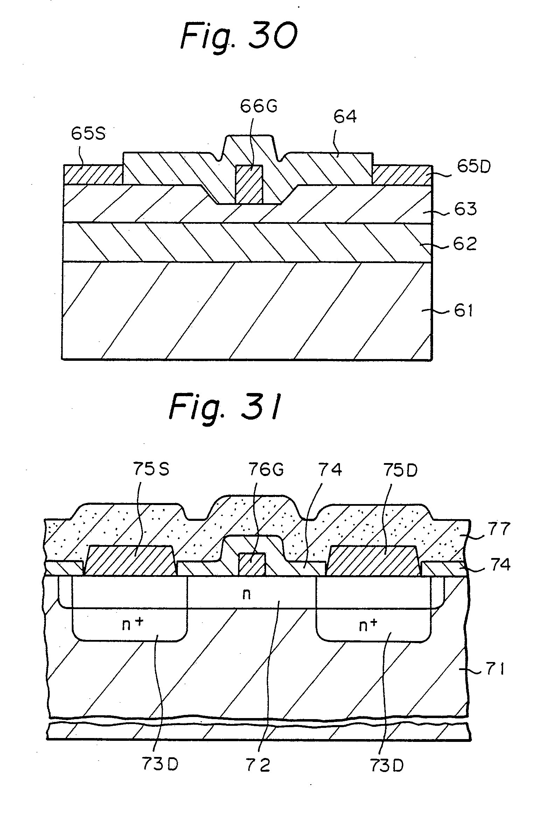

Figure 29 illustrates the high frequency characteristics of GaAs MESFETs having an $Al_xGa_{1-x}As$ passivation layer according to an embodiment of the invention and an $SiO_2$ passivation layer in the prior

art, respectively. In Figure 30, if applied to the three types of MESFETs described earlier with reference to Figure 2, the GaAs MESFET embodying the present invention corresponds to the C-Type, and the GaAs MESFET having an $SiO_2$ passivation layer corresponds to an intermediate one of the A-Type and B-Type. Correspondence of the GaAs MESFET according to the present invention to a C-Type is suggested by the fact that no gate leakage current is carried. The GaAs MESFET having an $SiO_2$ passivation layer is considered to be similar to the A-Type due to the linearity of the input power-output power characteristic, the power added efficiency, and the gate leakage current.

The GaAs MESFET embodying the present invention has an excellent linearity of the input power-output power characteristic, and its power added efficiency reaches up to 25%, although it belongs to the C-Type. Thus a GaAs MESFET having a high efficiency and without the appearance of gate leakage current can be provided by an embodiment of the present invention.

Figure 30 illustrates another embodiment of a GaAs MESFET according to the present invention, which is similar to a GaAs MESFET shown in Figures 24 to 27. In this embodiment, however, a refractory metal or a silicide thereof, for example, titanium tungsten silicide, is used as the material of a gate electrode 66G and an $Al_xGa_{1-x}As$ passivation layer 64 is formed not only on the exposed surface of an n-type GaAs active layer 63 between electrodes 65S, 65D and 66G, but also on the gate electrode 66G. Since a refractory metal or a silicide thereof can keep excellent Schottky contact with GaAs at a higher temperature, for example, at approximately 800°C, the $Al_xGa_{1-x}As$ passivation layer 54 can be formed after the gate electrode 66G of a refractory metal or a silicide thereof is formed, which allows the once removal of the alignment of a mask. Examples of the sizes in the Figure are as follows: length of a recess—1.5 μm, depth of the recess—300 nm, length of a gate 66G—1.0 μm, distance between source and drain electrodes 64S and 64D—5 μm.

A GaAs MESFET according to the present invention may be fabricated by using ion implantation technique. Referring to Figure 31, which however does not show the recessed structure according to the invention, an n-type active region 72 is formed in a semi-insulating GaAs substrate 71 by ion implantation of Si at 140 keV and $3\times10^{12}$ $cm^{-2}$, resulting in a doped carrier concentration of $1\times10^{17}$ $cm^{-3}$. A gate electrode 76 of a refractory metal or a silicide thereof is formed on the surface of the n-type active region 72. An $Al_xGa_{1-x}As$ passivation layer 74 is formed on the n-type active region 72 and on the gate electrode 76. The $Al_xGa_{1-x}As$ passivation layer 74 is selectively etched to form source and drain electrode contact windows through which selective ion implantation of Si at 120 kV and $2\times10^{13}$ $cm^{-2}$ is conducted to form an $n^+$-type source region 73S and an $n^+$-type drain region 73D. A source electrode 75S and a drain electrode 75D are formed in the source and drain electrode windows, respectively. An $SiO_2$ layer 77 is also formed.

The above descriptions are made with reference to $Al_xGa_{1-x}As$ and GaAs which are used for a passivation layer and an active layer, respectively, in a MESFET. However, similar improvement of the characteristics of a MESFET using a component semiconductor active layer can also be provided by other combinations of compound semiconductors as a passivation layer embodying to the present invention may have a lattice constant similar to that of an active layer of a compound semiconductor, which allows the prevention of the formation of interface states at the interface of the two compound semiconductor layers, or at least to decrease such interface states. The fact of such prevention or decrease was confirmed by the inventors of the present invention.

Further, a passivation layer according to an embodiment of the invention can be used not only in power transistors but also in other MESFETs, including those in various ICs.

**Claims**

1. A MESFET comprising:

— an active layer (53) of a first compound semiconductor having an outwardly-widening recess (53A) at the top surface thereof, the recess having inclined side walls on opposite sides thereof;
— source and drain electrodes (55S, 55D) on and in contact with the top surface of said active layer outside and on said opposite sides of said recess;
— a gate electrode (56G) on and in contact with said active layer in said recess and at a portion of the bottom of said recess between and spaced from each of said inclined side walls; and
— an insulating or semi-insulating layer (54) of a second compound semiconductor covering the top surface of said active layer and the surfaces of the inclined side walls and the bottom of the recess in the portions between said source, drain, and gate electrodes, said second compound semiconductor being composed of components including at least one of the components of said first compound semiconductor and having a forbidden band gap wider than that of said first compound semiconductor.

2. A MESFET according to claim 1, wherein said second compound semiconductor has a lattice constant similar to that of said first compound semiconductor.

3. A MESFET according to claim 1, wherein said first compound semiconductor is gallium arsenide and said second compound semiconductor is aluminum gallium arsenide.

4. A MESFET according to claim 3, wherein said aluminum gallium arsenide has the formula $Al_xGa_{1-x}As$ wherein x is between 0.2 and 0.5.

5. A MESFET according to claim 4, wherein said x is 0.3.

6. A MESFET according to claim 3, 4 or 5, wherein said aluminum gallium arsenide has a resisitivity of approximately $10^8$ Ωcm.

7. A MESFET according to claim 3, 4, 5 or 6, wherein said aluminum gallium arsenide has its said forbidden band gap between 1.7 eV to 1.95 eV.

8. A MESFET according to claim 3, 4, 5 or 6, wherein the forbidden band gap of the second semiconductor material is approximately 1.8 eV.

9. A MESFET according to claim 3, 4, 5, 6, 7 or 8, wherein the said aluminum gallium arsenide has a lattice constant of approximately 5.65 Å (0.565 nm).

10. A MESFET according to claim 1, wherein said first compound semiconductor is indium gallium arsenide having the formula $In_xGa_{1-x}As$ wherein x is 0.53, and said second compound semiconductor is indium phosphide.

11. A MESFET according to claim 1, wherein said first compound semiconductor is indium gallium arsenide having the formula $In_xGa_{1-x}As$ wherein x is 0.53, and said second compound semiconductor is aluminum indium arsenide having the formula $Al_yIn_{1-y}As$ wherein y is 0.48.

12. A MESFET according to claim 1, wherein said first compound semiconductor is indium phosphide and said second compound semiconductor is aluminum indium arsenide having the formula $Al_xIn_{1-x}As$ wherein x is 0.48.

13. A MESFET according to any preceding claim, having conducting lines (58) extending from said source, drain, and gate electrodes, and having bonding pads (58S) connected to those lines, wherein said insulating or semi-insulating layer extends under the conducting lines and the bonding pads.

14. A process for fabricating a MESFET according to any preceding claim, comprising the steps of:

forming an active layer (53) of a first compound semiconductor extending over a semi-insulating substrate (51);

forming an outwardly-widening recess (53A) having outwardly inclined side walls in the surface of said active layer at the region where a gate electrode is to be formed;

forming an insulating or semi-insulating layer (54) of a second compound semiconductor on the top surface of said active layer and of said recess, said second compound semiconductor being composed of constituents including at least one of the constituents of said first compound semiconductor and having its forbidden band gap wider than that of said first compound semiconductor; and

forming a source electrode (55S), a drain electrode (55D), and a gate electrode (56G) in contact with said active layer by opening windows in said insulating or semi-insulating layer and providing metal layer-form electrodes on the surface of said active layer within the windows, said gate electrode being situated on the bottom of said recess and spaced from the side walls thereof.

15. A process according to claim 14 wherein source and drain regions are formed in the active layer by ion implantation through the respective windows.

16. A process according to claim 14 or claim 15, wherein, after forming the active layer, the active layer and the semi-insulating substrate thereunder are selectively mesa-etched to form an island of said active layer, and said insulating or semi-insulating layer is then formed not only on the island of said active layer but also on said semi-insulating substrate exposed by said mesa-etching, whereby when conducting lines extending from said electrodes, and bonding pads connected to those lines, are formed, said insulating or semi-insulating layer separates the said conducting lines and bonding pads from the said semi-insulating substrate and the said active layer.

17. A process according to any one of claims 14 to 16 wherein said first and second compound semiconductors are as set forth in any one of claims 3 to 12.

**Patentansprüche**

1. MESFET mit:

- einer aktiven Schicht (53) aus einem ersten Verbindungshalbleiter, mit einer sich nach außen erweiternden Ausnehmung (53A) an der oberen Oberfläche desselben, welche Ausnehmung geneigte Seitenwände an ihren gegenüberliegenden Seiten hat;
- Source- und Drain-Elektroden (55S, 55D) an und in Kontakt mit der oberen Oberfläche der genannten aktiven Schicht außerhalb und auf gegenüberliegenden Seiten der genannten Ausnehmung;
- einer Gateelektrode (56G) auf und in Kontakt mit der genannten aktiven Schicht in der genannten Ausnhemung und an einem Abschnitt des Bodens der genannten Ausnehmung zwischen und im Abstand von jeder der genannten geneigten Seitenwände; und
- einer isolierenden oder halb-isolierenden Schicht (54) aus einem zweiten Verbindungshalbleiter, welche die obere Oberfläche der genannten aktiven Schicht und die Oberflächen von den genannten geneigten Seitenwänden und den Boden der Ausnehmung in den Abschnitten zwischen den genannten Source-, Drain- und Gateelektroden bedeckt, wobei der genannte zweite Verbindungshalbleiter zusammengesetzt ist aus Komponenten einschließlich wenigstens einer von den Komponenten von dem ersten Verbindungshalbleiter und eine verbotene Bandlücke hat, die breiter als diejenige des ersten Verbindungshalbleiters ist.

2. MESFET nach Anspruch 1, bei dem der genannte zweite Verbindungshalbleiter eine Gitterkonstante hat, die ähnlich derjenigen des genannten ersten Verbindungshalbleiters ist.

3. MESFET nach Anspruch 1, bei dem der genannte erste Verbindungshalbleiter Galliumarsenid und der genannte zweite Verbindungshalbleiter Aluminiumgalliumarsenid ist.

4. MESFET nach Anspruch 3, bei dem das genannte Aluminiumgalliumarsenid eine Gleichung $Al_xGa_{1-x}As$ hat, wobei x zwischen 0,2 und 0,5 liegt.

5. MESFET nach Anspruch 4, bei dem das genannte x 0,3 ist.

6. MESFET nach Anspruch 3, 4 oder 5, bei dem das genannte Aluminiumgalliumarsenid einen Widerstand von etwa $10^8$ Ωcm hat.

7. MESFET nach Anspruch 3, 4, 5 oder 6, bei dem das genannte Aluminiumgalliumarsenid seine genannte verbotene Bandlücke zwischen 1,7 eV und 1,95 eV hat.

8. MESFET nach Anspruch 3, 4, 5 oder 6, bei der die verbotene Bandlücke des zweiten Halbleitermaterials etwa 1,8 eV beträgt.

9. MESFET nach Anspruch 3, 4, 5, 6, 7 oder 8, bei dem das genannte Aluminiumgalliumarsenid eine Gitterkonstante von etwa 5,65 Å (0,565 nm) hat.

10. MESFET nach Anspruch 1, bei dem der genannte erste Verbindungshalbleiter Indiumgalliumarsenid ist und eine Formel $In_xGa_{1-x}As$ hat, wobei x 0,53 ist, und der genannte zweite Verbindungshalbleiter Indiumphosphid ist.

11. MESFET nach Anspruch 1, bei dem der genannte erste Verbindungshalbleiter Indiumgalliumarsenid ist und eine Formel $In_xGa_{1-x}As$ hat, wobei x 0,53 ist, und der genannte zweite Verbindungshalbleiter Aluminiumindiumarsenid ist, welches die Formel $Al_yIn_{1-y}As$ hat, wobei y 0,48 ist.

12. MESFET nach Anspruch 1, bei dem der genannte erste Verbindungshalbleiter Indiumphosphid ist und der genannte zweite Verbindungshalbleiter Aluminiumindiumarsenid ist und eine Formel $Al_xIn_{1-x}As$ hat, wobei x 0,48 ist.

13. MESFET nach einem der vorhergehenden Ansprüche, mit leitenden Leitungen (58), die sich von den genannten Source-, Drain- und Gateelektroden erstrecken, und Bonding-pads (58S) haben, die mit jenen Leitungen verbunden sind, wobei die genannte isolierende oder halb-isolierende Schicht sich unter den leitenden Leitungen und den Bonding pads erstreckt.

14. Verfahren zur Herstellung eines MESFET nach einem der vorhergehenden Ansprüche, mit den folgenden Schritten:

Bildung einer aktiven Schicht (53) aus einem ersten Verbindungshalbleiter, die sich über einem halb-isolierenden Substrat (51) erstreckt;

Bildung einer sich nach außen erweiternden Ausnehmung (53A), welche nach außen geneigte Seitenwände hat, in der Oberfläche der genannten aktiven Schicht an einem Bereich, wo eine Gateelektrode gebildet werden soll;

Bildung einer isolierenden oder halb-isolierenden Schicht (54) aus einem zweiten Verbindungshalbleiter auf der oberen Oberfläche der genannten aktiven Schicht und der genannten Ausnehmung, welcher genannte zweite Verbindungshalbleiter zusammengesetzt ist aus Bestandteilen, die wenigstens einen der Bestandteile von dem genannten ersten Verbindungshalbleiter umfassen und dessen verbotene Bandlücke breiter als diejenige des genannten ersten Verbindungshalbleiters ist; und

Bildung einer Sourceelektrode (55S), einer Drainelektrode (55D) und einer Gateelektrode (56G) in Berührung mit der genannten aktiven Schicht durch Öffnung von Fenstern in der genannten isolierenden oder halbisolierenden Schicht und Vorsehen von schichtförmigen Metallelektroden auf der Oberfläche der genannten aktiven Schicht innerhalb der Fenster, welche Gateelektrode auf dem Boden der genannten Ausnehmung und in einem Abstand von deren Seitenwänden angeordnet ist.

15. Verfahren nach Anspruch 14, bei dem Source- und Drainbereiche in der aktiven Schicht durch Ionenimplantation durch die jeweiligen Fenster gebildet werden.

16. Verfahren nach Anspruch 14 oder 15, bei dem, nach Bildung der aktiven Schicht, die aktive Schicht und das halbisolierende Substrat darunter selektiv mesa-geätzt werden, um eine Insel aus der genannten aktiven Schicht zu bilden, und die ganannte isolierende oder halbisolierende Schicht dann nicht nur auf der Insel aus der genannten aktiven Schicht sondern auch auf dem genannten halb-isolierenden Substrat, welches durch die genannte mesa-Ätzung exponiert ist, gebildet wird, wodurch dann, wenn leitende Leitungen, die sich von den genannten Elektroden erstrecken und Bonding pads, die mit jenen Leitungen verbunden sind, gebildet werden, wobei die genannte isolierende oder halbisolierende Schicht die genannten leitenden Leitungen und Bonding pads von dem genannten halb-isolierenden Substrat und der genannten aktiven Schicht trennt.

17. Verfahren nach einem der Ansprüche 14 bis 16, bei dem der genannte erste und der genannte zweite Verbindungshalbleiter wie in irgendeinem der Ansprüche 3 bis 12 beschrieben sind.

**Revendications**

1. MESFET comprenant:

— une couche active (53) d'un premier semiconducteur composé comprenant un évidement (53A) s'ouvrant vers l'extérieur au niveau de sa surface supérieure, l'évidement comprenant des parois latérales inclinées sur ses côtés opposés;

— des électrodes de source et de drain (55S, 55D) sur, et en contact avec, la surface supérieure de la couche active en dehors et au dessus desdits côtés opposés de l'évidement;

— une électrode de grille (56G) sur, et en contact avec, la couche active dans l'évidement et au niveau d'une partie du fond de l'évidement entre chacune des parois latérales inclinées et de façon espacée par rapport à celles-ci; et

— une couche isolante ou semi-isolante (54) d'une second semiconducteur composé recouvrant la surface supérieure de la couche active et les surfaces des parois latérales inclinées et le fond de l'évidement dans les parties comprises entre les électrodes de source, de drain et de grille, le second semiconducteur composé étant constitué de composants comprenant au moins l'un des composants du premier semiconducteur composé et présentant un intervalle de bande interdite plus large que celui du premier semiconducteur composé.

2. MESFET selon la revendication 1, dans lequel le second semiconducteur composé a une constante de maille similaire à celle du premier semiconducteur composé.

3. MESFET selon la revendication 1, dans lequel le premier semiconducteur composé est de l'arséniure de gallium et le second semiconducteur composé de l'arséniure d'aluminium-gallium.

4. MESFET selon la revendication 3, dans lequel l'arséniure d'aluminium-gallium présente la formule $Al_xGa_{1-x}As$ où x est compris entre 0,2 et 0,5.

5. MESFET selon la revendiation 4, dans lequel x est égal à 0,3.

6. MESFET selon l'une des revendications 3, 4 ou 5 dans lequel l'arséniure d'aluminium-gallium a une résistivité d'environ $10^8$ Ωcm.

7. MESFET selon l'une des revendications 3, 4, 5 ou 6 dans lequel l'arséniure d'aluminium-gallium a son intervalle de bande interdite compris entre 1,7 eV et 1,95 eV.

8. MESFET selon l'une des revendications 3, 4, 5 ou 6, dans lequel l'intervalle de bande interdite du second matériau semiconducteur est approximativement égal à 1,8 eV.

9. MESFET selon l'une des revendications 3, 4, 5, 6, 7 ou 8 dans lequel l'arséniure d'aluminium-gallium a une constante de maille approximativement égale à 5,65 Å (0,565 nm).

10. MESFET selon la revendication 1, dans lequel le premier semiconducteur composé est de l'arséniure d'indium-gallium ayant la formule $In_xGa_{1-x}As$, où x est égal à 0,54, et le second semiconducteur composé est du phosphure d'indium.

11. MESFET selon la revendication 1, dans lequel le premier semiconducteur composé est de l'arséniure d'indium-gallium ayant la formule $In_xGa_{1-x}As$ où x est égal à 0,53 et le second semiconducteur composé est de l'arséniure d'aluminium-indium ayant la formule $Al_yIn_{1-y}As$ où y est égal 0,48.

12. MESFET selon la revendication 1, dans lequel le premier semiconducteur composé est du phosphure d'indium et le second semiconducteur composé est de l'arséniure d'aluminium-indium ayant la formule $Al_xIn_{1-x}As$ où x est égal, 0,48.

13. MESFET selon l'une quelconque des revendications précédentes comprenant des lignes conductrices (58) s'étendant à partir des électrodes de source, de drain et de grille et comprenant des plots de liaison (58S) connectés à ces lignes, dans lequel la couche isolante ou semi-isolante s'étend sous les lignes conductrices et les plots de liaison.

14. Procédé de fabrication d'un MESFET selon l'une quelconque des revendications précédentes comprenant les étapes suivantes:

former une couche active (53) d'un premier semiconducteur composé s'étendant au dessus d'un substrat semiisolant (51);

former un évidement s'élargissant vers l'extérieur (53A) ayant des parois latérales inclinées vers l'extérieur dans la surface de ladite couche active au niveau de la région où une électrode de grille doit être formée;

former une couche isolante ou semi-isolante (54) d'un second semiconducteur composé sur la surface supérieure de la couche active et de l'évidement, le second semiconducteur composé étant formé de constituants comprenant au moins l'un des constituants du premier semiconducteur composé et ayant son intervalle de bande interdite plus large que celui du premier semiconducteur composé; et

former une électrode de source (55S), une électrode de drain (55D) et une électrode de grille (56G) en contact avec la couche active en ouvrant des fenêtres dans la couche isolante ou semi-isolante et en prévoyant des électrodes sous forme d'une couche métallique sur la surface de la couche active dans les fenêtres, l'électrode de grille étant située au fond de l'évidement et espacée de ses parois latérales.

15. Procédé selon la revendication 14, dans lequel les régions de source et de drain sont formées dans la couche active par implantation ionique à travers les fenêtres respectives.

16. Procédé selon la revendication 14 ou la revendication 15 dans lequel, après formation de la couche active, la couche active et le substrat semi-isolant sous celle-ci sont attaqués sélectivement sous forme mésa pour former un îlot de ladite couche active, et la couche isolante ou semi-isolante est alors formée non seulement sur l'îlot sur la couche active mais également sur le substrat semi-isolant exposé par l'attaque mésa, d'où il résulte que, quand des lignes conductrices s'étendant à partir des électrodes et que des plots de liaison connectés à ces lignes sont formées, la couche isolante ou semi-isolante sépare lesdites lignes conductrices et lesdits plots de liaison du substrat semi-isolant et de la couche active.

17. Procédé selon l'une quelconque des revendications 14 à 16, dans lequel les premier et second semiconducteurs composés sont tels qu'indiqués dans l'une quelconque des revendications 3 à 12.

Fig. 1a

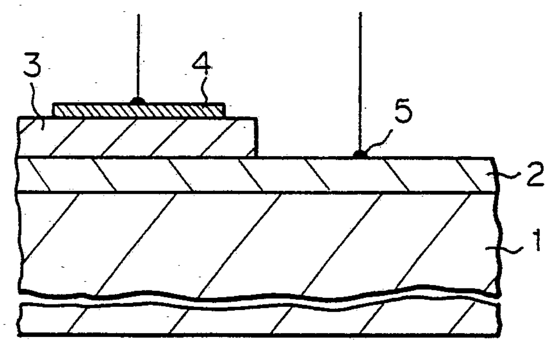
3
4
5
2
1

Fig. 1b

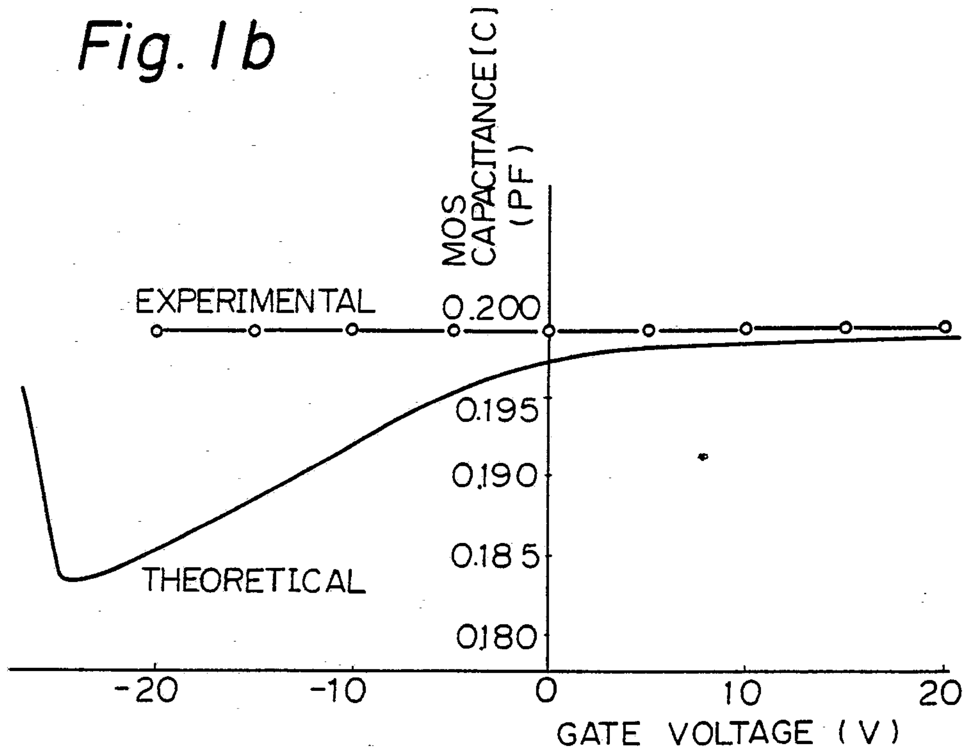
MOS CAPACITANCE [C] (PF)
EXPERIMENTAL
THEORETICAL
0.200
0.195
0.190
0.185
0.180
-20
-10
0
10
20
GATE VOLTAGE (V)

*Fig. 2*

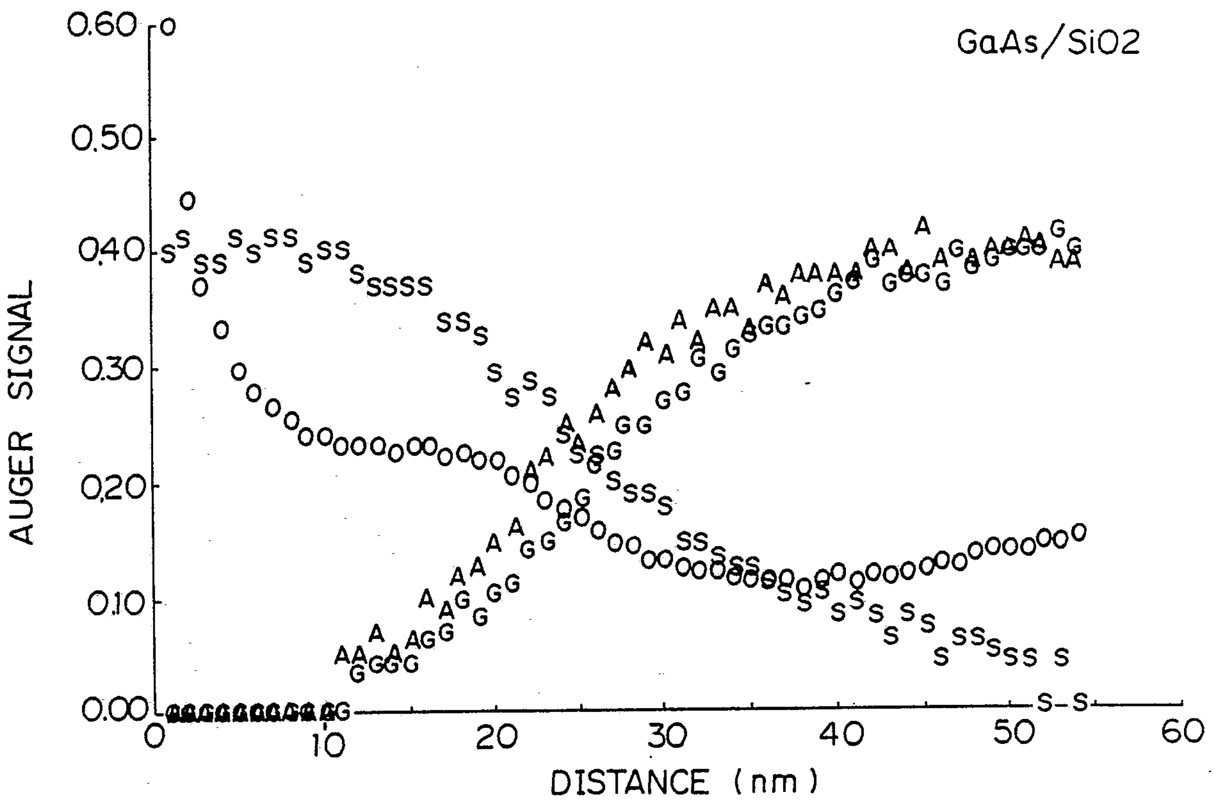
GaAs/SiO2
AUGER SIGNAL
0.00
0.10
0.20
0.30
0.40
0.50
0.60
0
10
20
30
40
50
60
DISTANCE (nm)

Fig. 3a

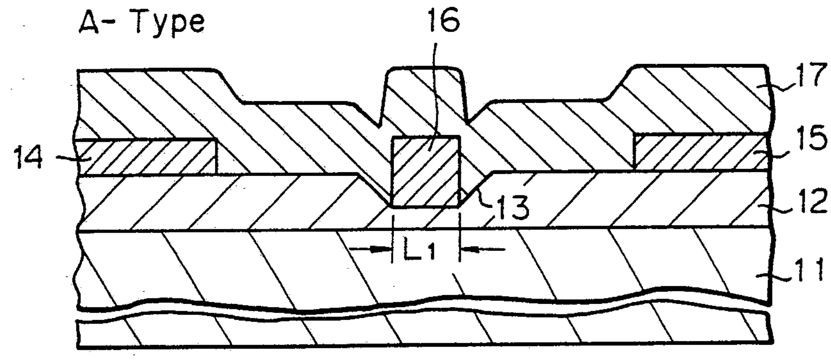


Fig. 3b

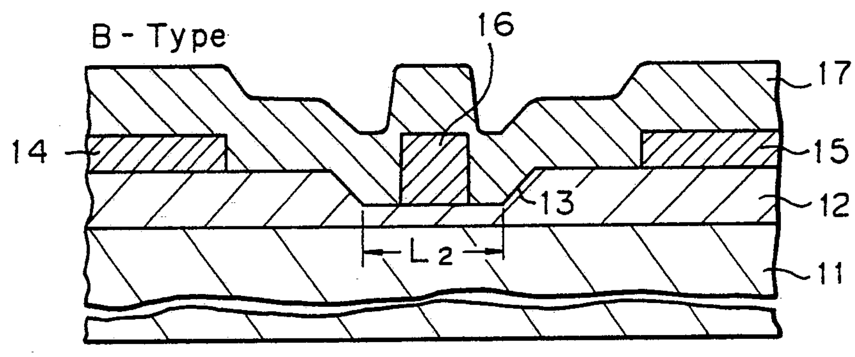


Fig. 3c

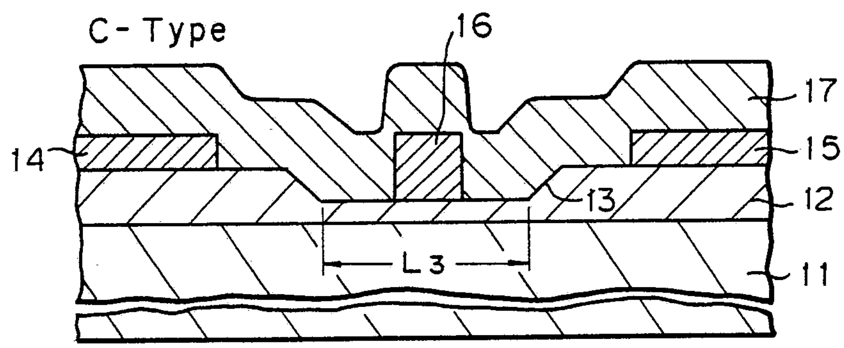

Fig. 4

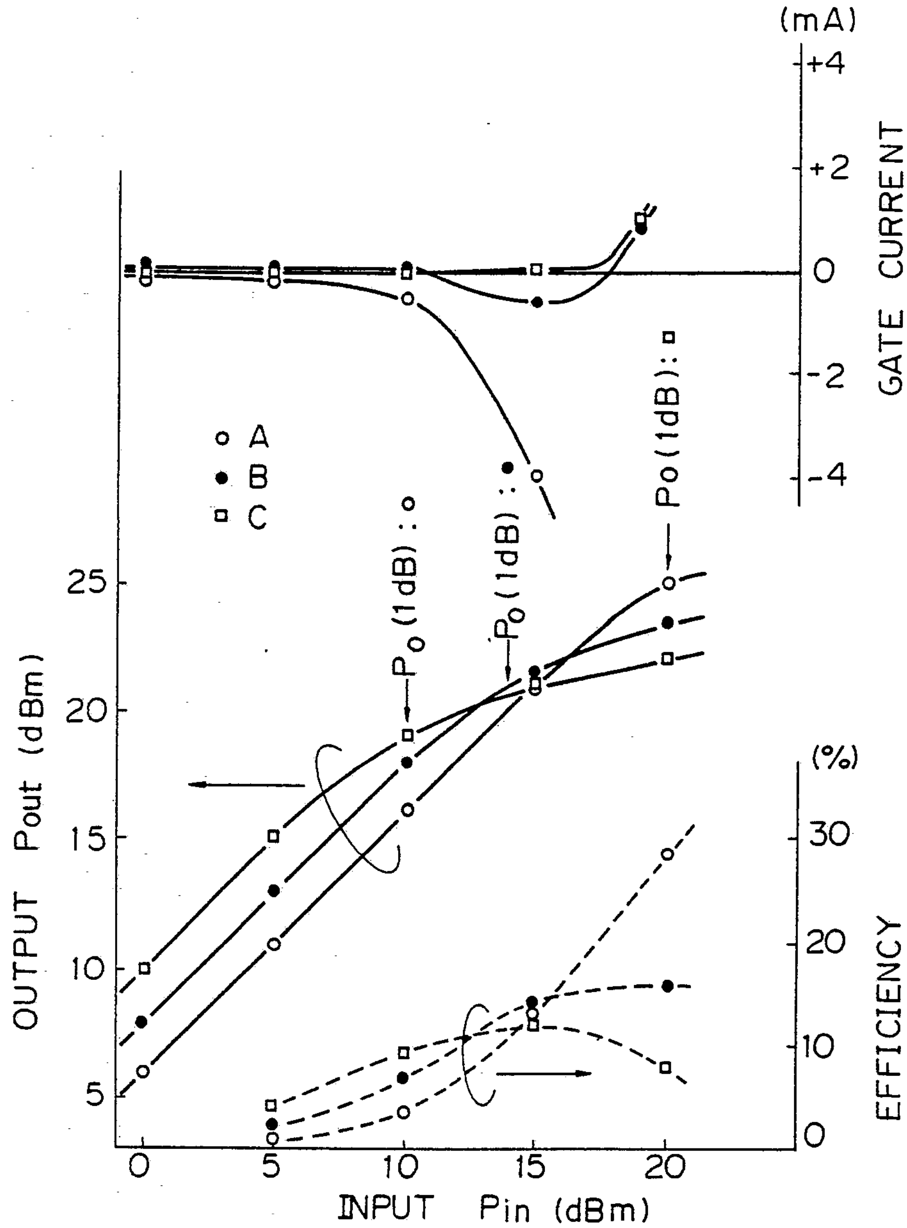
(mA)
+4
+2
0
-2
-4
GATE CURRENT
○ A
● B
□ C
$P_o$(1dB) : ○
$P_o$(1dB) : ●
Po(1dB) : □
25
20
15
10
5
OUTPUT Pout (dBm)
(%)
30
20
10
0
EFFICIENCY
0
5
10
15
20
INPUT Pin (dBm)

Fig. 5

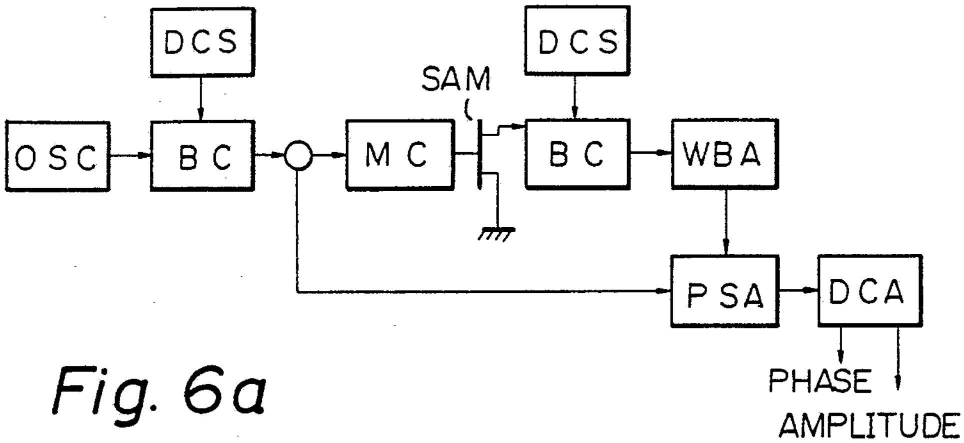


Fig. 6a

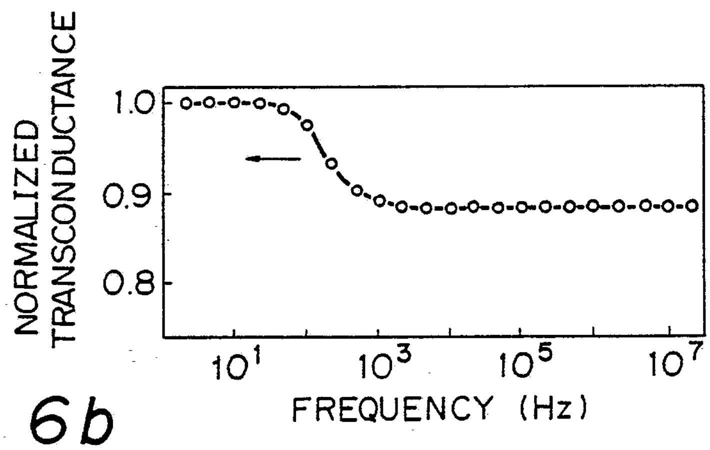


Fig. 6b

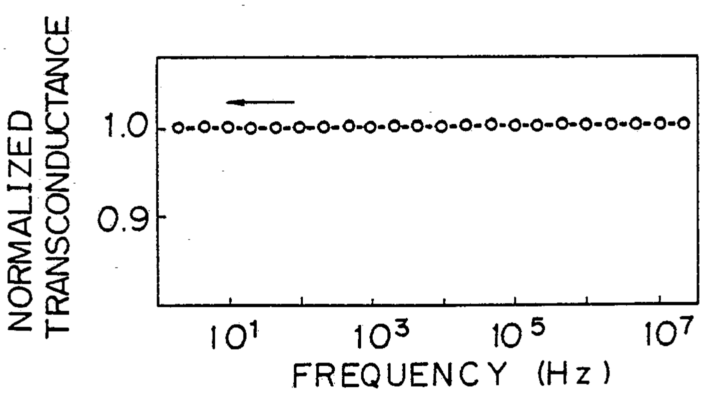

Fig. 7

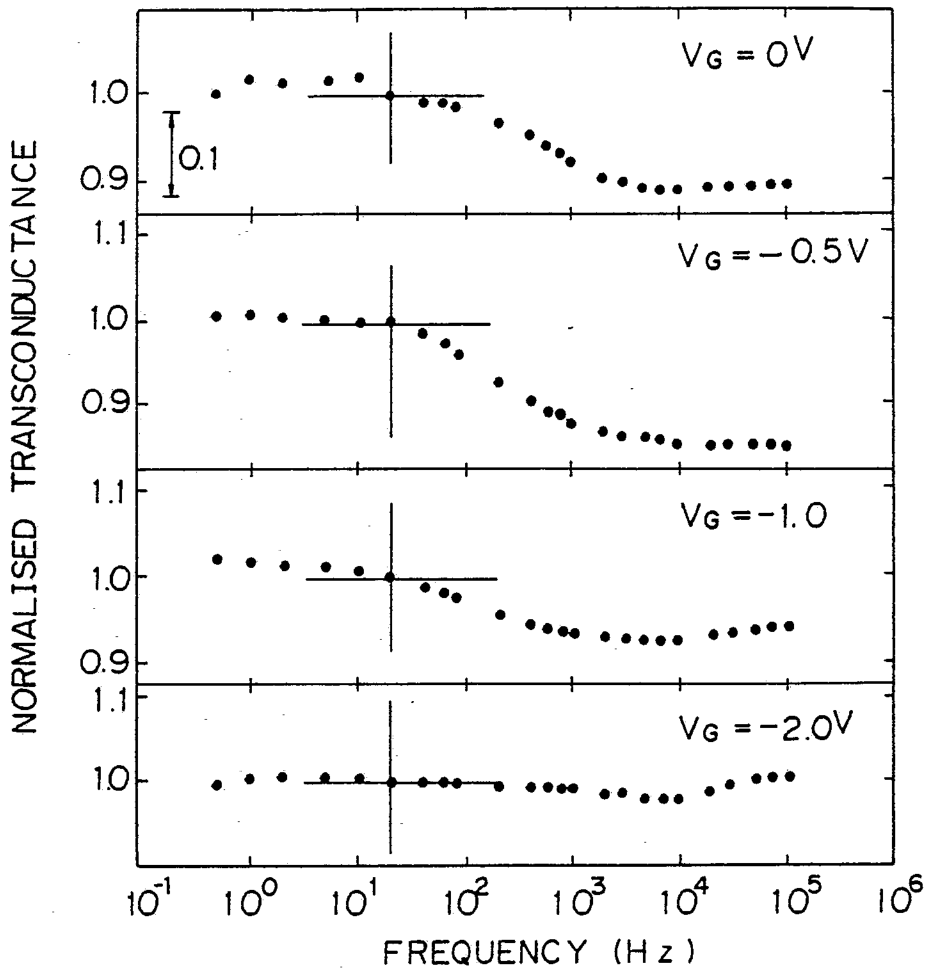
NORMALISED TRANSCONDUCTANCE
VG = 0V
VG = −0.5V
VG = −1.0
VG = −2.0V
0.1
1.1
1.0
0.9
10⁻¹ 10⁰ 10¹ 10² 10³ 10⁴ 10⁵ 10⁶
FREQUENCY (Hz)

Fig. 8

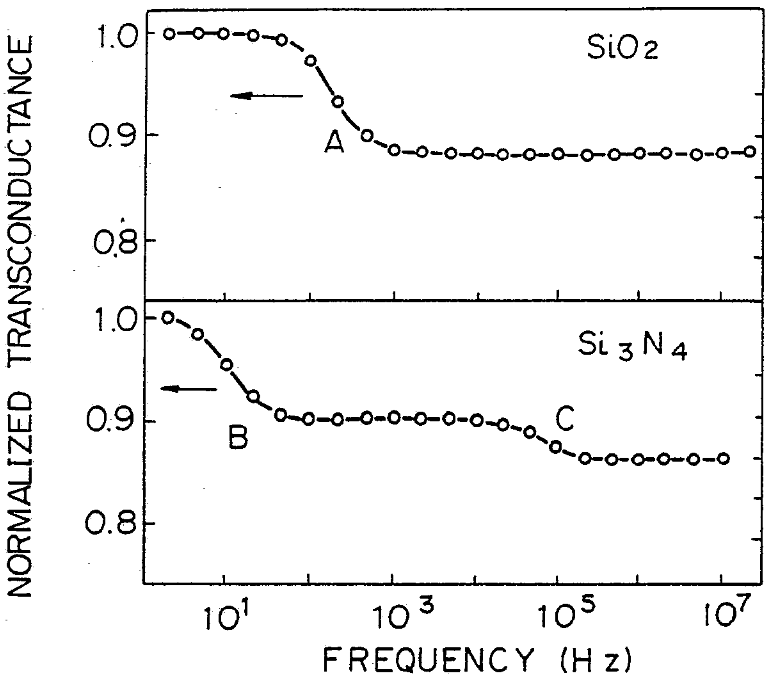
NORMALIZED TRANSCONDUCTANCE
1.0
0.9
0.8
SiO2
A
1.0
0.9
0.8
Si 3 N 4
B
C
10¹
10³
10⁵
10⁷
FREQUENCY (Hz)

Fig. 9

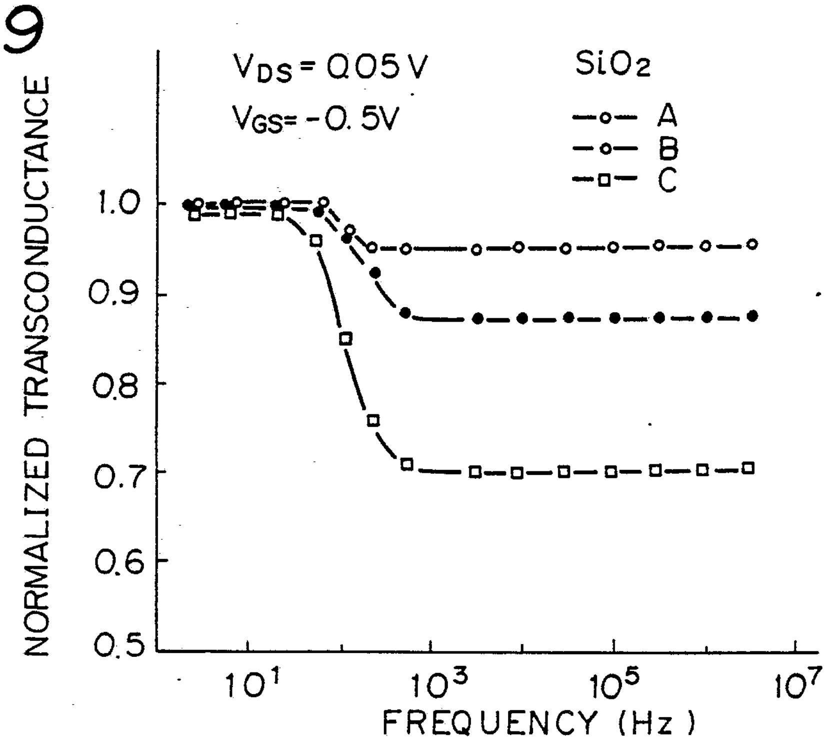
VDS = 0.05 V
VGS = -0.5V
SiO2
A
B
C
NORMALIZED TRANSCONDUCTANCE
1.0
0.9
0.8
0.7
0.6
0.5
10¹
10³
10⁵
10⁷
FREQUENCY (Hz)

Fig. 10a

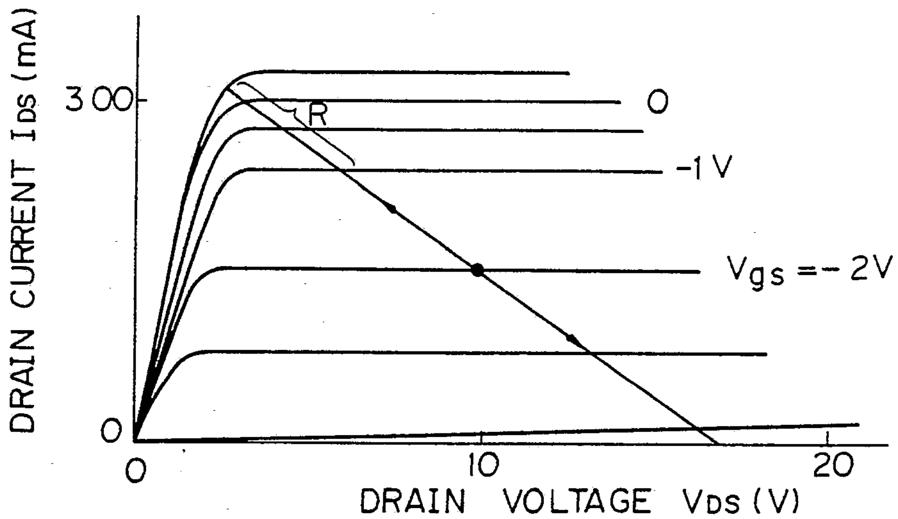


Fig. 10b

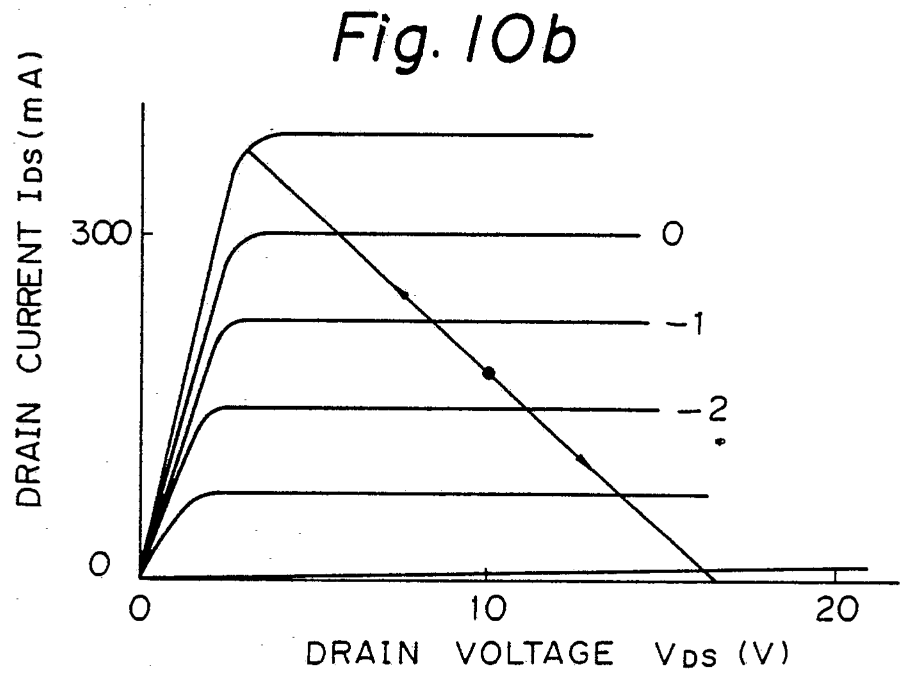

Fig. 11

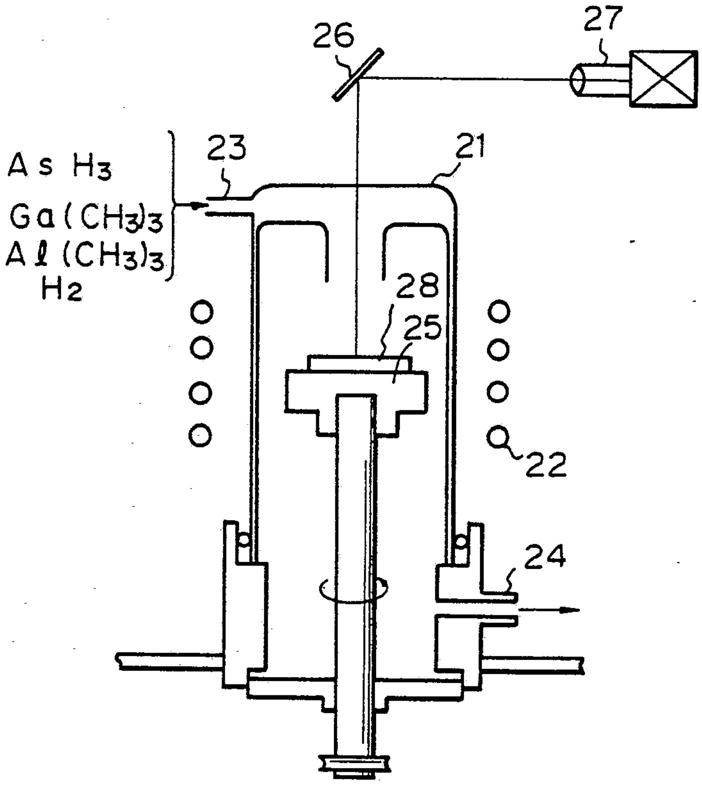

Fig. 12

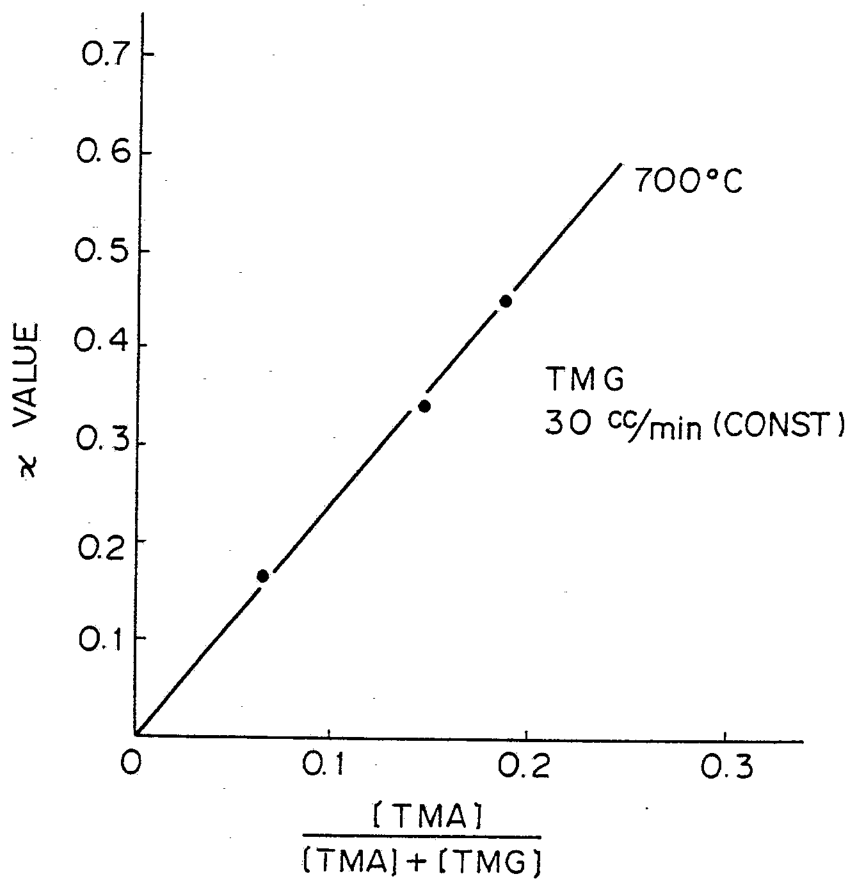
0.7
0.6
0.5
0.4
0.3
0.2
0.1
x VALUE
700°C
TMG
30 cc/min (CONST)
0
0.1
0.2
0.3
[TMA] / ([TMA] + [TMG])

Fig. 13

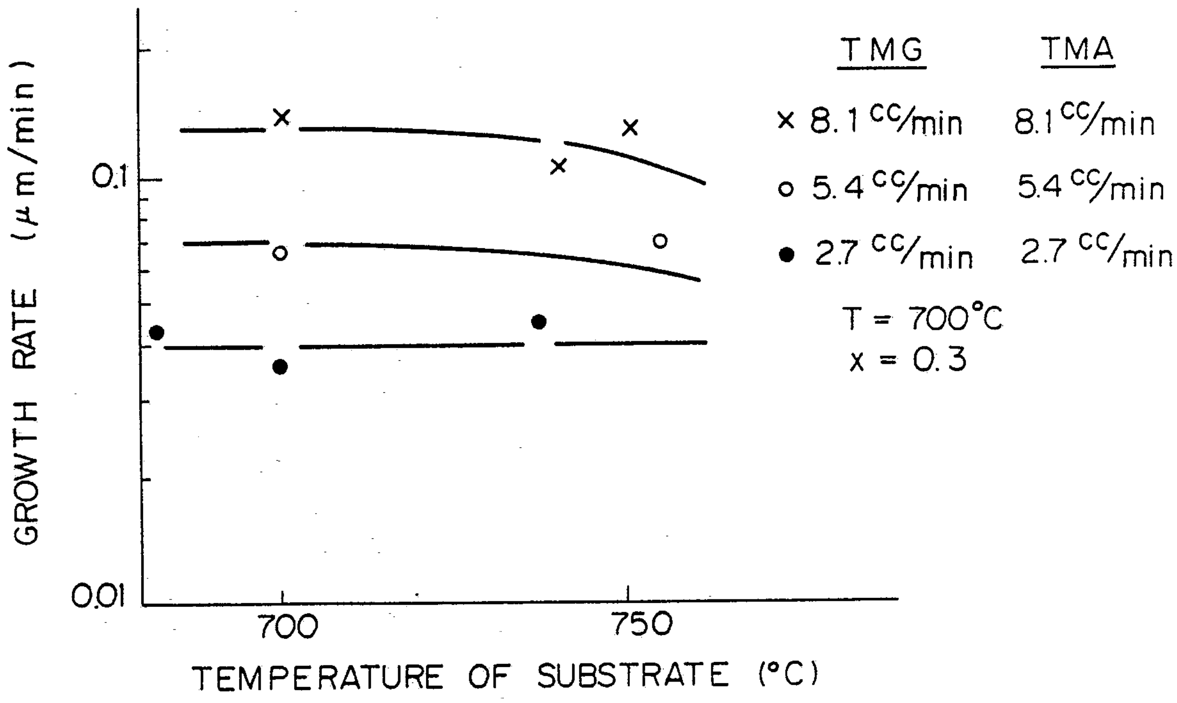
GROWTH RATE (μm/min)
0.1
0.01
700
750
TEMPERATURE OF SUBSTRATE (°C)
TMG
TMA
× 8.1 cc/min 8.1 cc/min
○ 5.4 cc/min 5.4 cc/min
● 2.7 cc/min 2.7 cc/min
T = 700°C
x = 0.3

Fig. 14

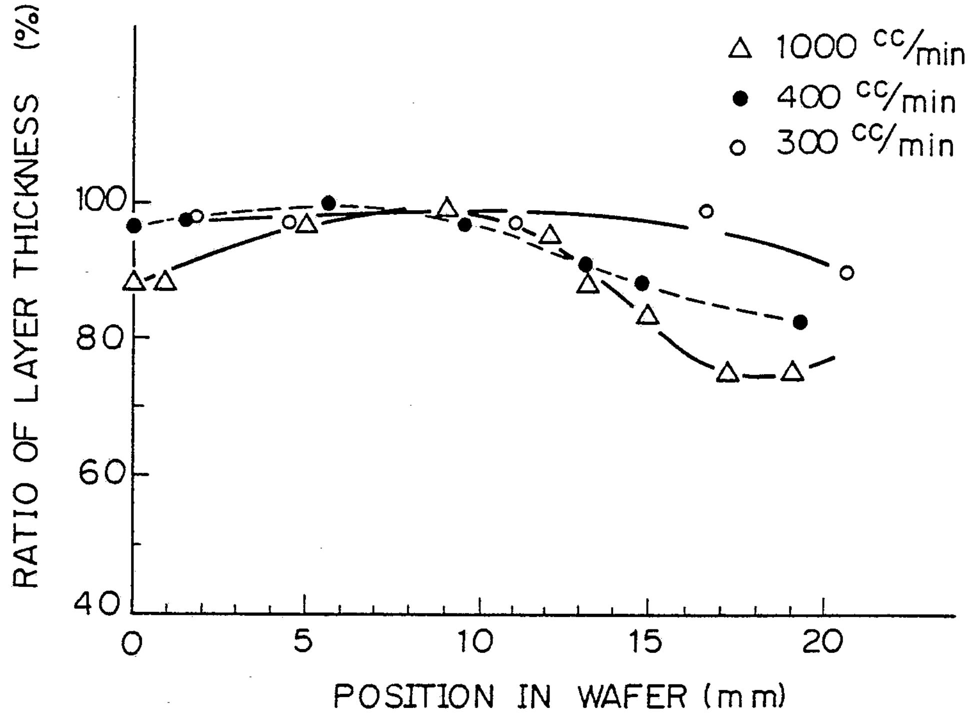
RATIO OF LAYER THICKNESS (%)
100
80
60
40
0
5
10
15
20
POSITION IN WAFER (mm)
△ 1000 cc/min
● 400 cc/min
○ 300 cc/min

Fig. 15

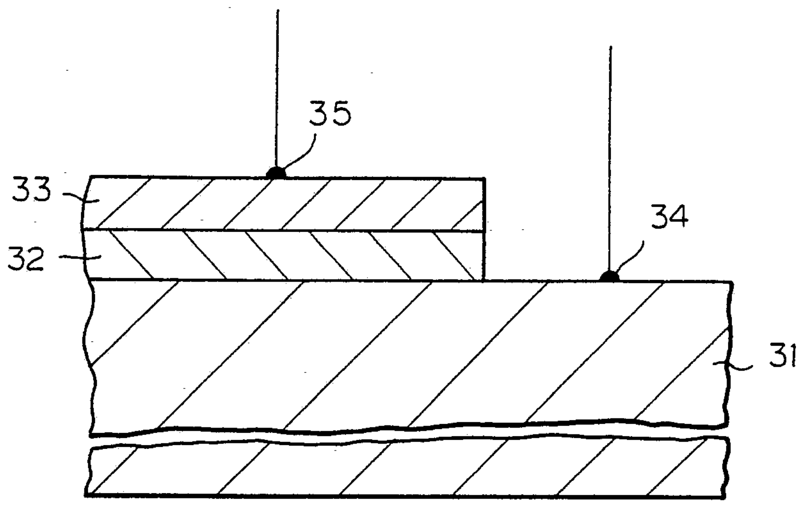


Fig. 16

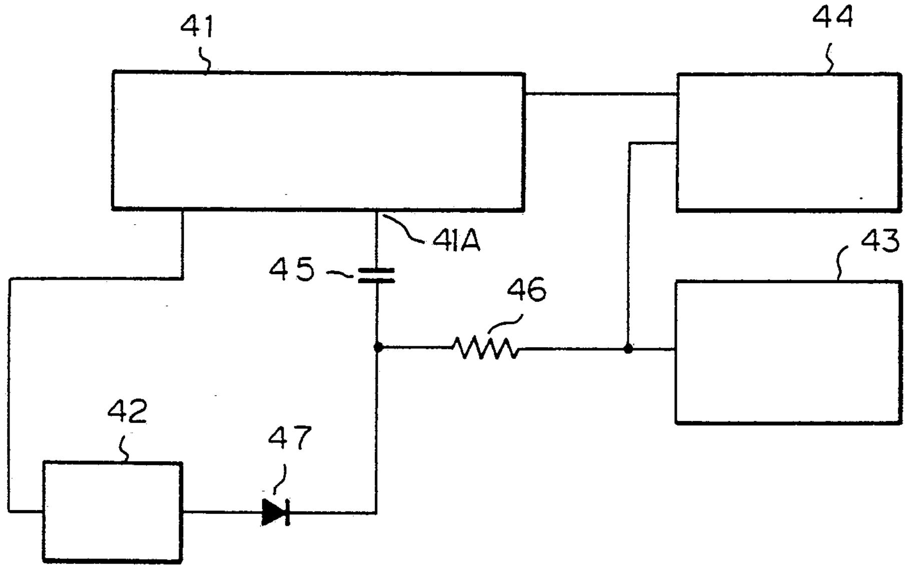

*Fig. 17*

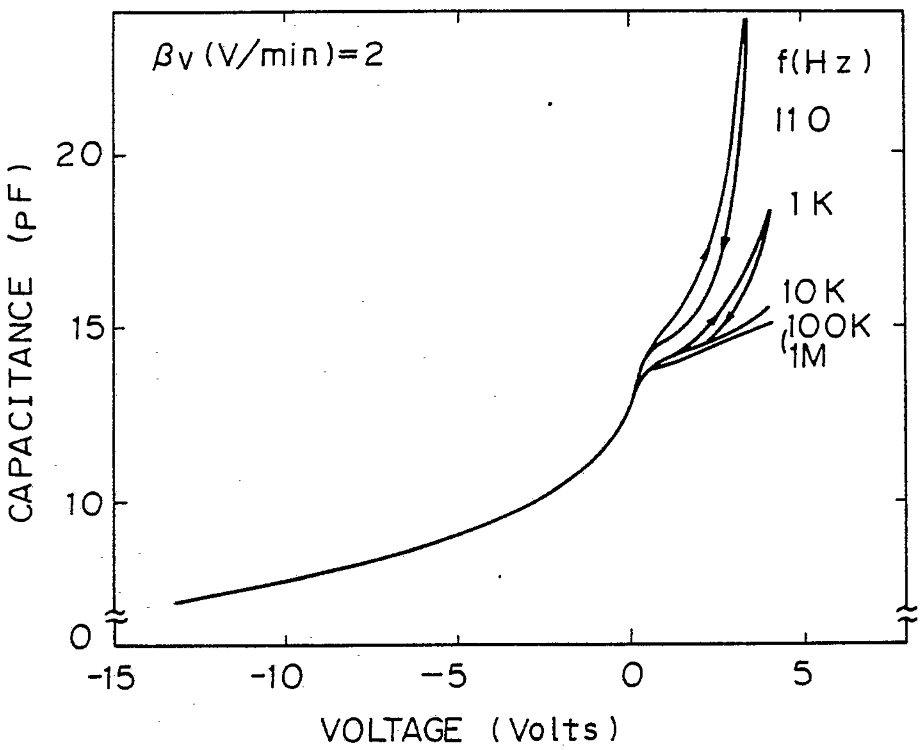
βv (V/min)=2
f(Hz)
110
1K
10K
100K
1M
CAPACITANCE (pF)
20
15
10
0
-15
-10
-5
0
5
VOLTAGE (Volts)

Fig. 18

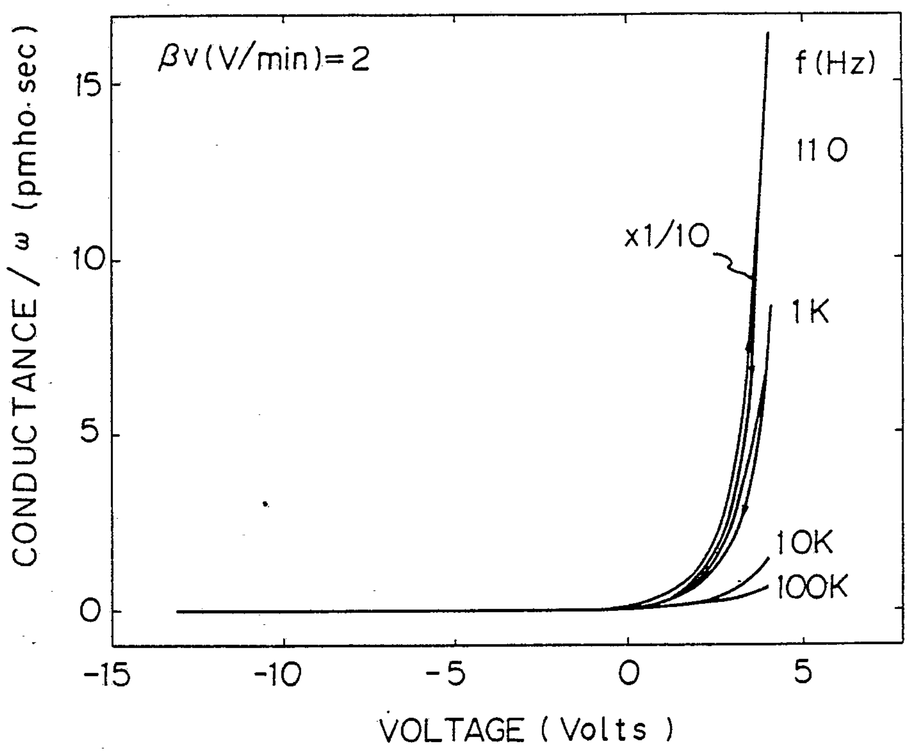
βv(V/min)=2
f(Hz)
110
x1/10
1K
10K
100K
CONDUCTANCE / ω (pmho·sec)
15
10
5
0
-15
-10
-5
0
5
VOLTAGE ( Volts )

Fig. 19

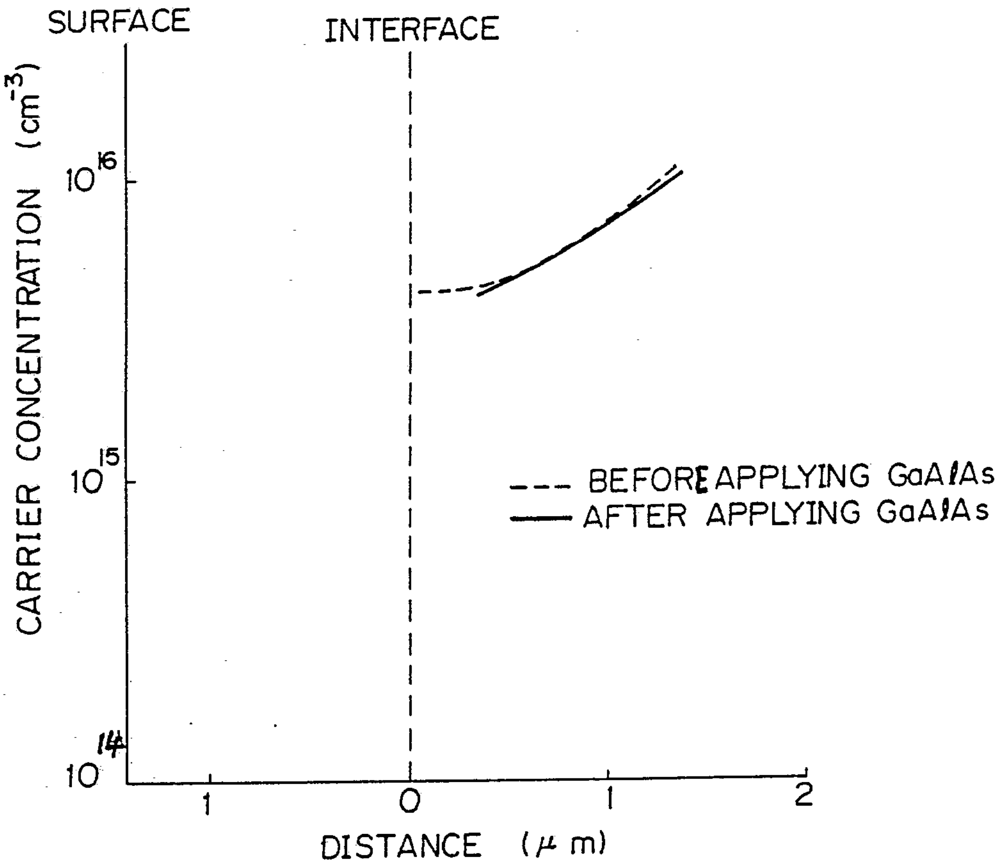
SURFACE
INTERFACE
CARRIER CONCENTRATION (cm-3)
10^16
10^15
10^14
1
0
1
2
DISTANCE (μ m)
BEFORE APPLYING GaAlAs
AFTER APPLYING GaAlAs

Fig. 20

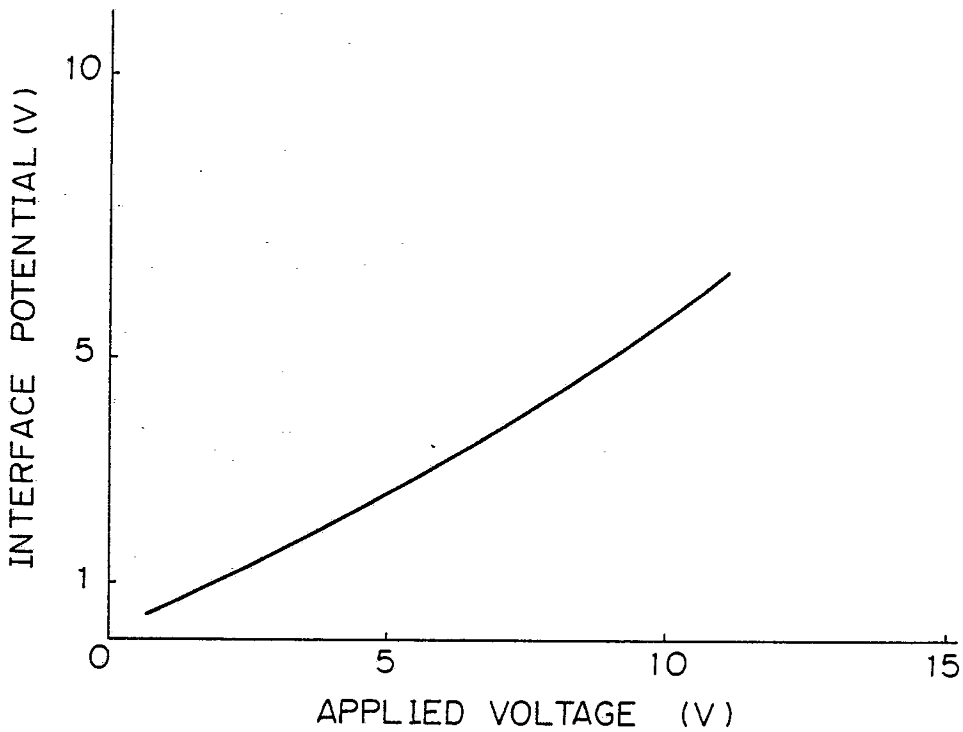

*Fig. 21*

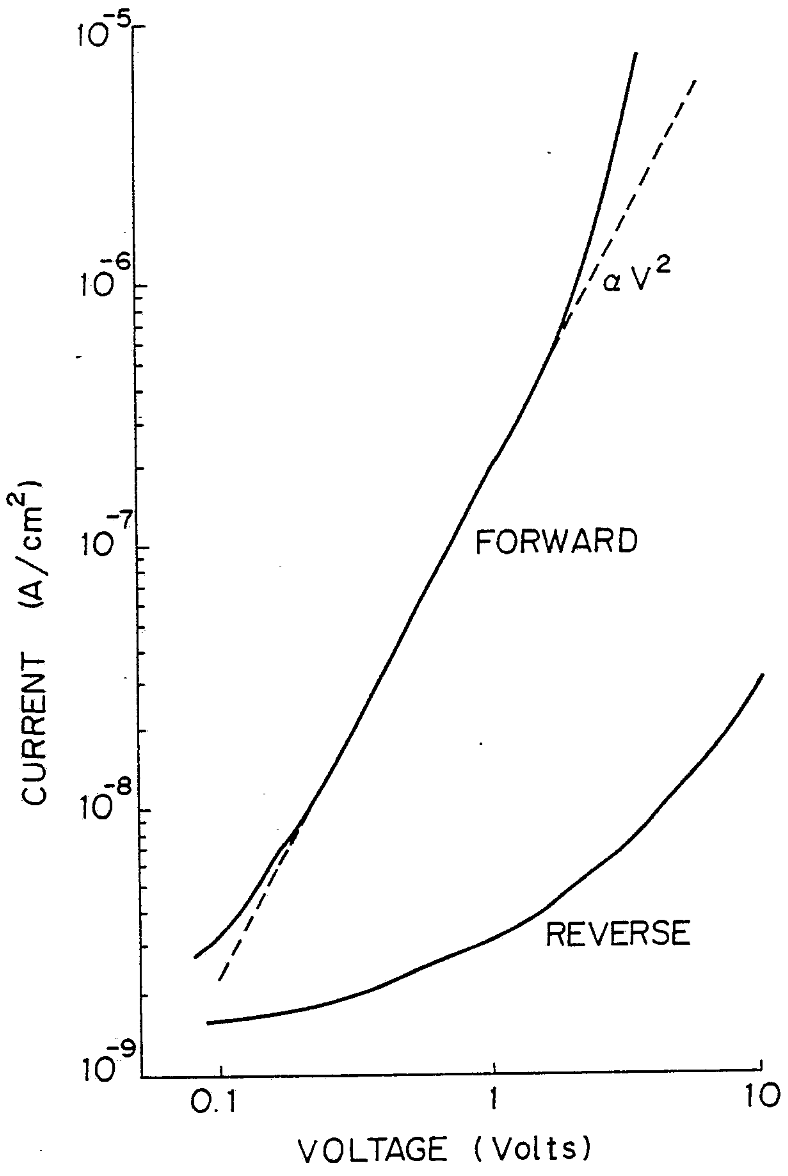
$10^{-5}$
$10^{-6}$
$10^{-7}$
$10^{-8}$
$10^{-9}$
CURRENT (A/cm$^2$)
$\alpha V^2$
FORWARD
REVERSE
0.1
1
10
VOLTAGE (Volts)

# Fig. 22

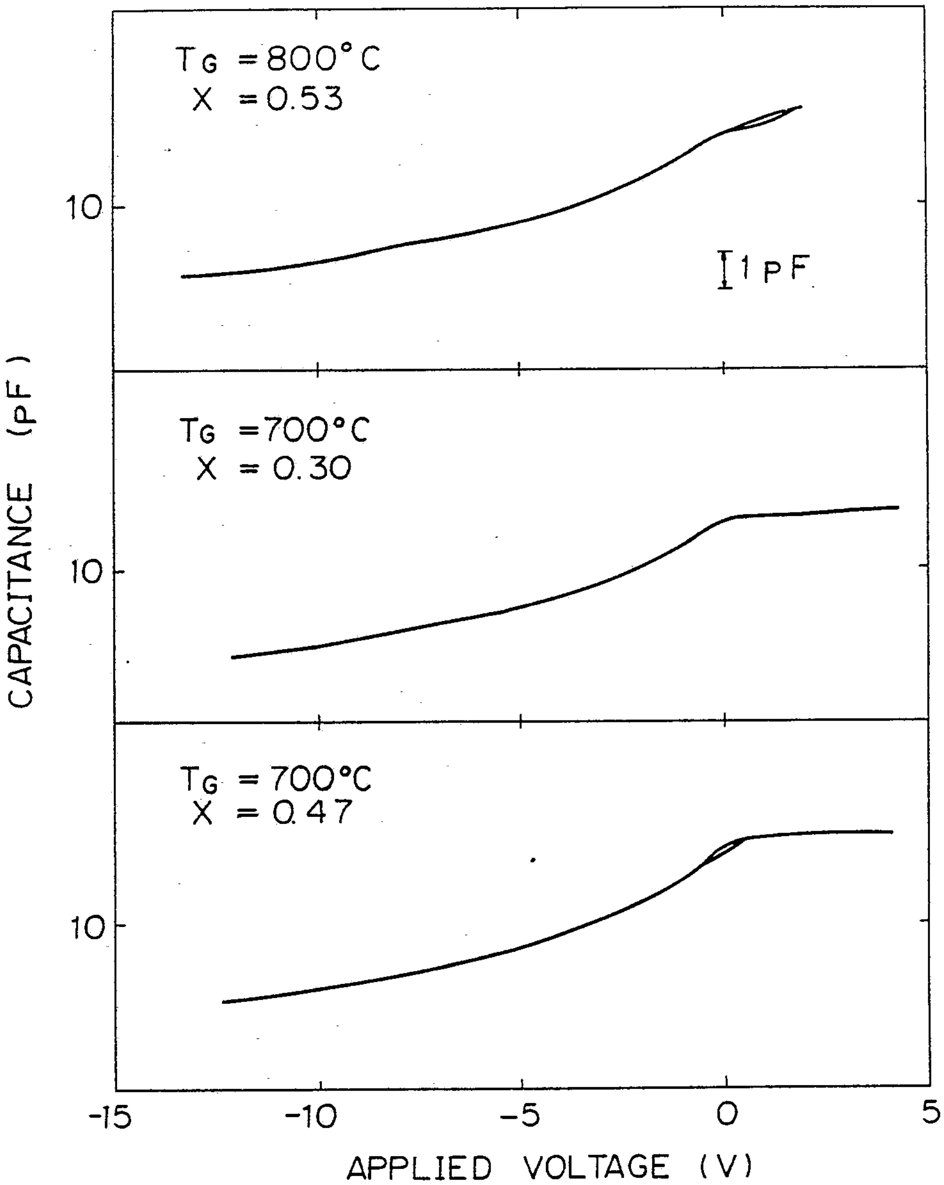
TG =800°C
X =0.53
TG =700°C
X = 0.30
TG = 700°C
X = 0.47
10
10
10
1 pF
CAPACITANCE (pF)
-15
-10
-5
0
5
APPLIED VOLTAGE (V)

Fig. 23

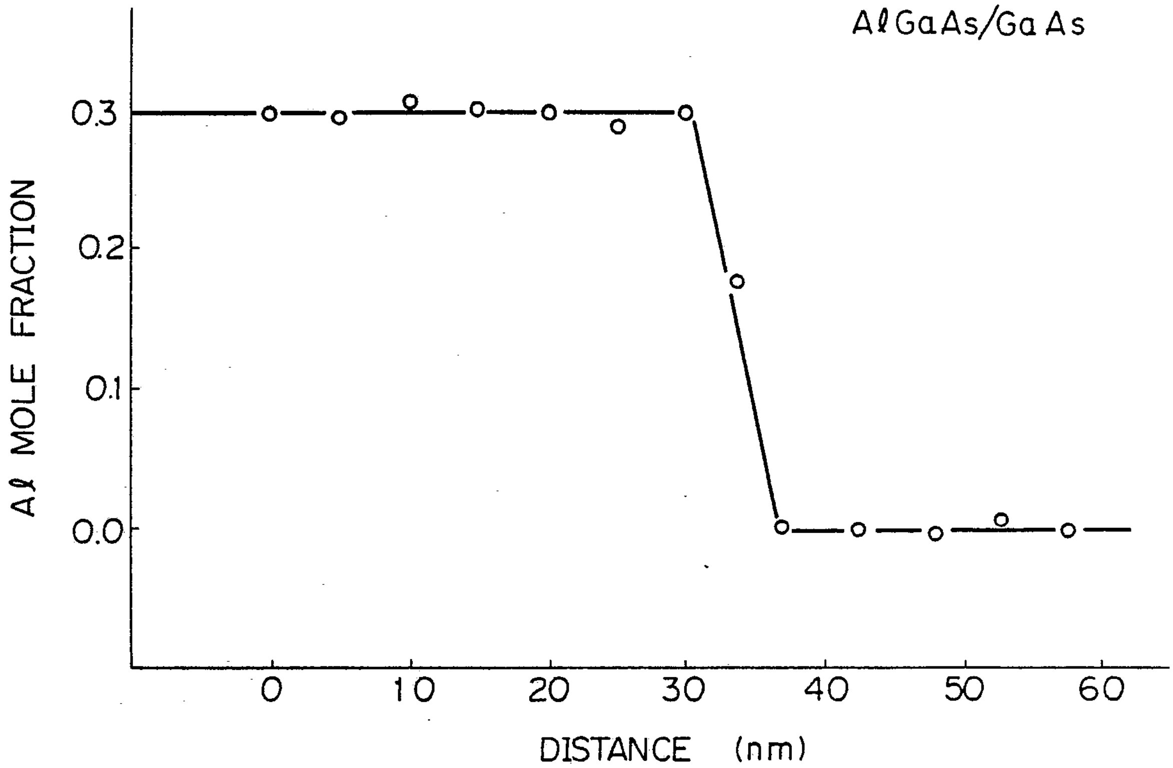
AℓGaAs/GaAs
0.3
0.2
0.1
0.0
Aℓ MOLE FRACTION
0
10
20
30
40
50
60
DISTANCE (nm)

Fig. 24

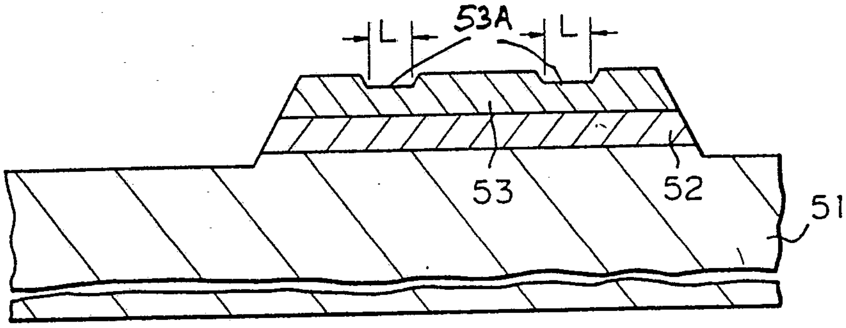


Fig. 25

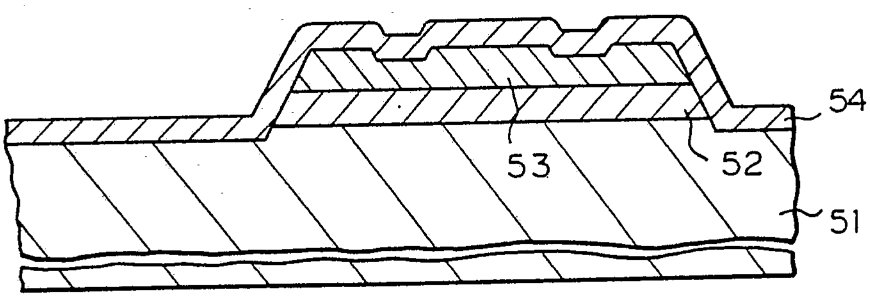

Fig. 26

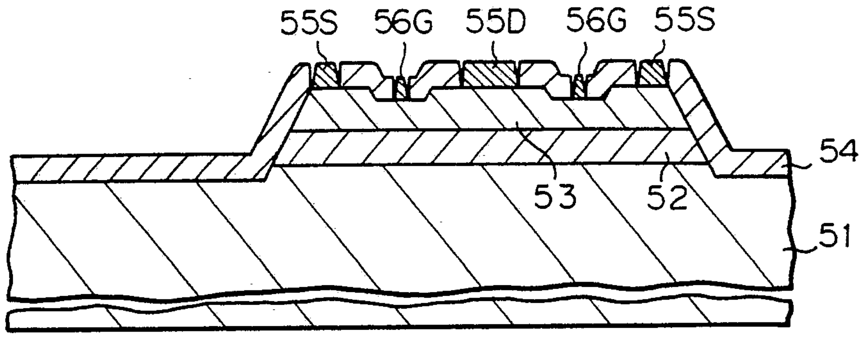


Fig. 27

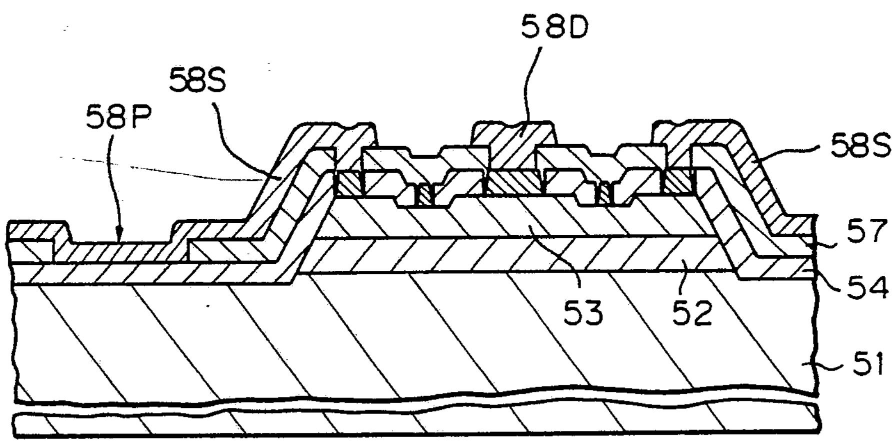

Fig. 28

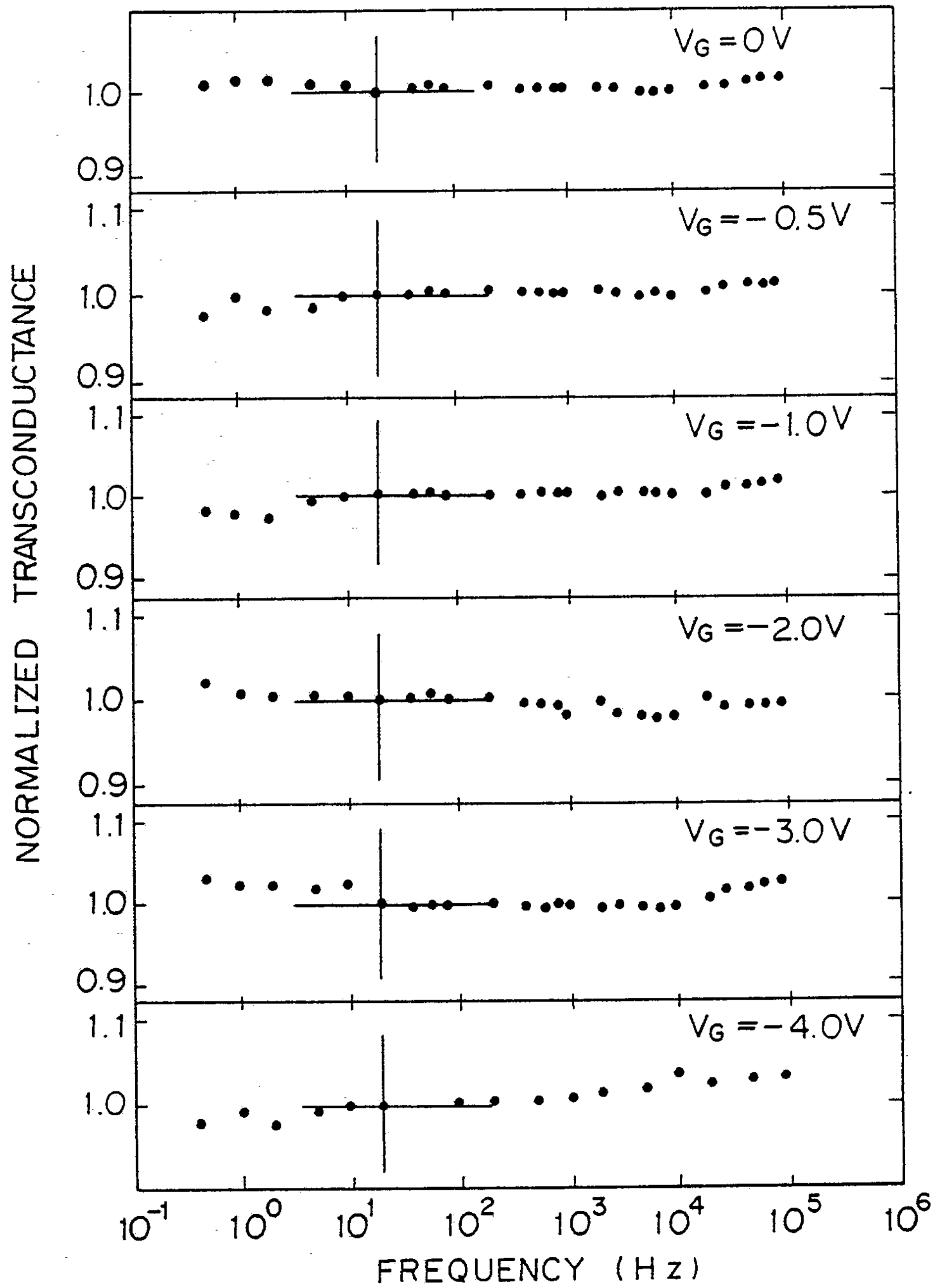

$V_G = 0V$
$V_G = -0.5V$
$V_G = -1.0V$
$V_G = -2.0V$
$V_G = -3.0V$
$V_G = -4.0V$
1.1
1.0
0.9
NORMALIZED TRANSCONDUCTANCE
$10^{-1}$ $10^0$ $10^1$ $10^2$ $10^3$ $10^4$ $10^5$ $10^6$
FREQUENCY (Hz)

Fig. 29

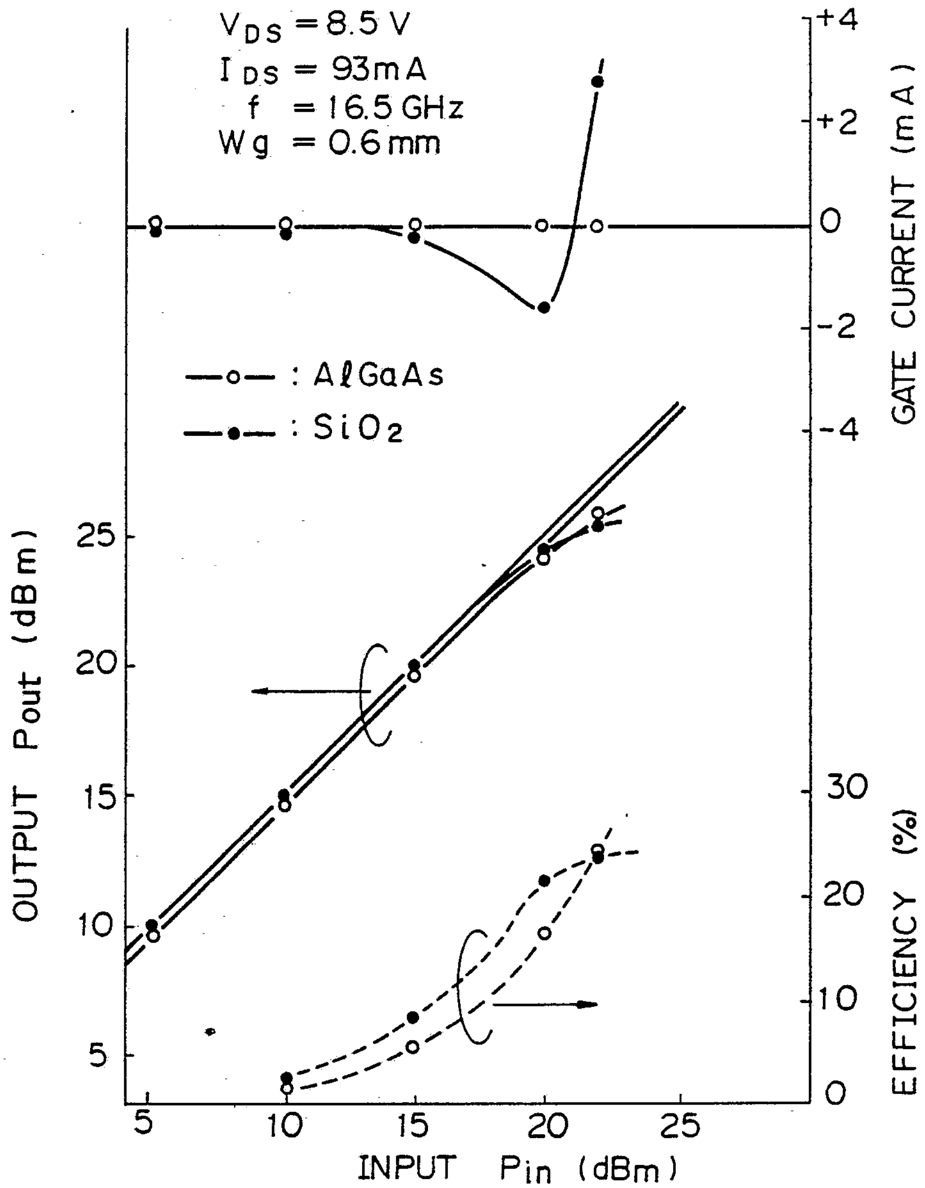
$V_{DS}$ = 8.5 V
$I_{DS}$ = 93mA
f = 16.5 GHz
Wg = 0.6 mm
—o— : AℓGaAs
—●— : $SiO_2$
+4
+2
0
-2
-4
GATE CURRENT (mA)
OUTPUT $P_{out}$ (dBm)
25
20
15
10
5
30
20
10
0
EFFICIENCY (%)
5
10
15
20
25
INPUT $P_{in}$ (dBm)

Fig. 30

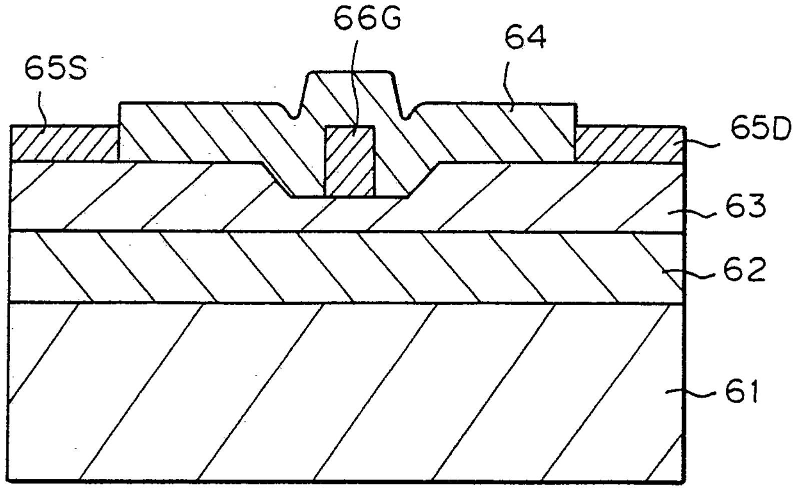


Fig. 31